# EUROPEAN PATENT APPLICATION

(11) **EP 2 003 703 A2**
(43) Date of publication of application: **17.12.2008**
(21) Application number: 07708068.7
(22) Date of filing: 05.02.2007
(51) Int. Cl.: H01L 33/00, H01S 5/024

(54) **HEAT PIPE**

(30) Priority: 03.04.2006 JP 2006101822; 02.08.2006 JP 2006211074
(71) Applicant: Fuchigami Micro Co.,Ltd., Kagoshima-shi, Kagoshima 891-0122 (JP)
(72) Inventor: UEDA, Susumu, Kagoshima-shi, Kagoshima 891-0122 (JP); OHSAWA, Kenji, Kagoshima-shi, Kagoshima 891-0122 (JP); TSURUTA, Katsuya, Kagoshima-shi, Kagoshima 891-0122 (JP); KOTANI, Toshiaki, Kagoshima-shi, Kagoshima 891-0122 (JP)
(74) Representative: Maillet, Alain
(86) International application number: PCT/JP2007/051950
(87) International publication number: WO 2007/113942

(57) **Abstract**

A cooling unit main body 25 having vapor diffusion flow paths 42 which extend to the peripheral portion and capillary flow paths 41 formed between the vapor diffusion flow paths 42 and in a concave portion opposite region 47 is provided with a thin concave portion 6 in which an LED chip 2 is mounted. Accordingly, heat from the LED chip 2 can be easily transferred by what corresponds to the thinning of the concave portion 6, and successive circulating phenomenon caused by a refrigerant W is repeated by the heat, and the heat is surely drawn from the LED chip 2 by latent heat at a time when the refrigerant W vaporizes, so that a heat pipe 5 can maintain the light emitting state of the LED chip 2 stably.

## Description

### TECHNICAL FIELD

The present invention relates to a heat pipe, and more particularly, a heat pipe which effectively diffuses heat generated at a light emitting unit, thereby suppressing temperature rising threat.

### BACKGROUND ART

An example of a device which requires a heat pipe is a light emitting device equipped with LEDs (Light Emitting Device). LEDs are used in various applications, and for an illumination purpose, development of a high power LED is advanced, and generation of heat becomes noticeable. Heat generation causes a light emitting state unstable, resulting in abnormal light emission, so that a cooling device (heat pipe) which has a function of cooling an LED chip becomes necessary to keep a light emitting state stable (e.g., see Patent Literature 1, Patent Literature 2 and Patent Literature 3).

LEDs are widely used in game machines and other electric devices, and cooling devices for suppressing temperature rising of a light emitting unit becomes necessary to maintain the light emitting state of an LED appropriately. The spaces inside those electronic devices, however, are limited, and to miniaturize the electronic devices, it is necessary to miniaturize the cooling device.
Patent Literature 1: Japanese Unexamined Patent Publication No. 2005-79467
Patent Literature 2: Japanese Unexamined Patent Publication No. 2006-54211
Patent Literature 3: Japanese Unexamined Patent Publication No. 2005-64047

### DISCLOSURE OF THE INVENTION

### PROBLEMS TO BE SOLVED BY THE INVENTION

A cooling device disclosed in Patent Literature 1 is used for projection type display devices, and provided on, as illustrated in FIG. 30, a light source device that comprises a solid light source 251 which emits light, and a substrate 252 for mounting the solid light source 251, a concave portion 253 is formed in the substrate 252, the solid light source 251 is disposed on the recess portion 253 in such a manner as to cover the recess portion 253, and the recess portion 253 and the solid light source 251 form a flow path 254 through which a refrigerant performing heat exchange with the solid light source 251 flows.

According to the foregoing structure, because the solid light source 251 is directly cooled down by the refrigerant, a cooling effect is superior, but it is necessary to provide insulation films on the walls of the flow path of the refrigerant because the refrigerant is electrically conductive. In a case where the substrate 252 is formed of a metal with a high heat radiation property like aluminum, it is necessary to form an insulating layer 256 on a boundary to an electrode 255. Further, a circulation pump is required to circulate the refrigerant, so that the device structure becomes complicated.

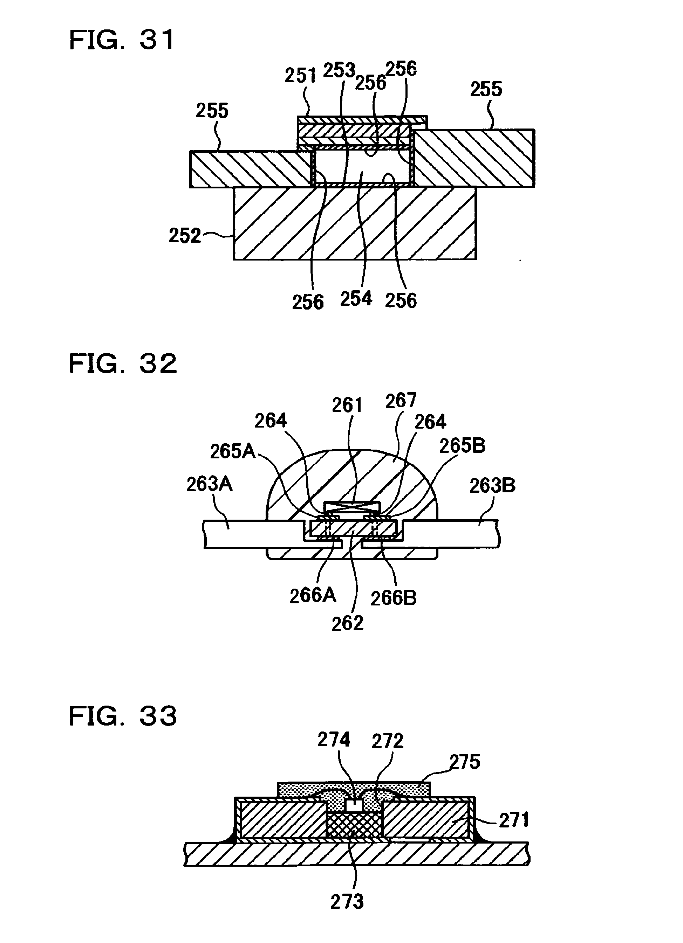

A cooling device disclosed in Patent Literature 2 is mounted on a light emitting device used for LED traffic signals and white light emitting LED lamps, and as illustrated in FIG. 31, an LED element 261 is mounted on a sub mount 262 which is mounted on the leading ends of leads 263A, 263B of a lead frame, electrodes 265A, 265B are formed between the LED element 261 and the sub mount 262 through bumps 264, electrodes 266A, 266B are formed between the leading ends of the leads 263A, 263B and the sub mount 262, and the leads 263A, 263B, the LED element 261, and the sub mount 262 are sealed by a seal member 267 made of a glass.

According to the foregoing structure, the used seal member 267 made of a glass is not molded without applying a heat of 450 °C or so, so that the device may be subjected to heat stress. It is necessary to provide the sub mount 262 which has a large heat capacity for heat radiation.

A cooling device disclosed in Patent Literature 3 is provided on a light emitting device used for household devices, such as a personal computer, a printer, a PDA, a facsimile, a pager, and a cellular phone, and as illustrated in FIG. 32, a high heat radiation member 273 made of A1, Cu, or the like is fixed in a through hole 272 formed in the approximate center of a circuit board 271 made of a glass epoxy resin, an LED chip 274 is mounted on the upper surface of the high heat radiation member 273, and the light emitting device is sealed by a translucent resin 275 in such a manner as to cover the LED chip 274.

According to the foregoing structure, the thickness of the high heat radiation member 273 is limited, so that it is difficult to obtain a good heat dissipation effect.

The necessities of the foregoing cooling devices are not limited to the case of LEDs, but the same is true in other light emitting devices like laser diodes, and small size light emitting devices having a superior cooling function are demanded. To achieve a sufficient cooling function, it is necessary that a member constituting a cooling unit is structured in such a manner as to sufficiently withstand heat radiation.

Heat pipes as cooling devices for cooling such light emitting devices are required for not only the light emitting devices, but also required for efficiently cooling various devices subject to cooling like CPUs (Central Processing Unit) which always operate at a fast speed and generate large amount of heat, and for the heat pipes, it is desired to facilitate conduction of heat from a cooling target device to a refrigerant to thereby improve thermal conductivity while maintaining the thin structure of the heat pipes, and to prevent the cooling target device from operating in an unstable state due to heat.

The present invention has been made in view of the foregoing problems, and it is an object of the invention to provide a small size heat pipe which facilitates conduction of heat from a cooling target device more, surely continues cooling the cooling target device, thereby maintaining the operation state of the cooling target device stable.

Another object of the invention is to provide a small size heat pipe which improves a heat dissipation effect in comparison with conventional heat pipes.

### MEANS FOR SOLVING THE PROBLEMS

To achieve the objects, a heat pipe of the invention comprises:
a cooling unit main body having an upper plate and a lower plate, either one of which being provided with a mounting section for mounting a device to be cooled, and one or a plurality of intermediate plates provided between the upper plate and the lower plate, wherein
a vapor diffusion flow path which causes a refrigerant to vaporize and transfer heat generated at the device to be cooled to a peripheral portion of the cooling unit main body, and a capillary flow path which is provided in the intermediate plate and returns the refrigerant that is condensed at the peripheral portion to the mounting section side are provided inside the cooling unit main body, and
the mounting section has a concave portion which has a thinner thickness than other areas and is for mounting the device to be cooled.

The heat pipe of the invention may comprise:
a cooling unit main body having an upper plate and a lower plate, either one of which being provided with a mounting section for mounting a device to be cooled, and one or a plurality of intermediate plates provided between the upper plate and the lower plate, wherein
a vapor diffusion flow path which causes a refrigerant to vaporize and transfer heat generated at the device to be cooled to a peripheral portion of the cooling unit main body, and a capillary flow path which is provided in the intermediate plate and returns the refrigerant that is condensed at the peripheral portion to the mounting section side are provided inside the cooling unit main body, and
the capillary flow path is formed inside the cooling unit main body in a region facing the mounting section.
The heat pipe of the invention may comprise:
a cooling unit main body having an upper plate and a lower plate, either one of which being provided with a mounting section for mounting a device to be cooled, and one or a plurality of intermediate plates provided between the upper plate and the lower plate, wherein
a vapor diffusion flow path which causes a refrigerant to vaporize and transfer heat generated at the device to be cooled to a peripheral portion of the cooling unit main body, and a capillary flow path which is provided in the intermediate plate and returns the refrigerant that is condensed at the peripheral portion to the mounting section side are provided inside the cooling unit main body, and
a heat dissipation fin is provided at an outer peripheral portion of any one of the upper plate, the lower plate, and the intermediate plate.
Further, the heat pipe of the invention may comprise:
a cooling unit main body having an upper plate and a lower plate, either one of which being provided with a mounting section for mounting a device to be cooled, and one or a plurality of intermediate plates provided between the upper plate and the lower plate, wherein
a vapor diffusion flow path which causes a refrigerant to vaporize and transfer heat generated at the device to be cooled to a peripheral portion of the cooling unit main body, and a capillary flow path which is provided in the intermediate plate and returns the refrigerant that is condensed at the peripheral portion to the mounting section side are provided inside the cooling unit main body,
the mounting section has a concave portion which has a thinner thickness than other areas and is for mounting the device to be cooled,
the capillary flow path is formed inside the cooling unit main body in a region facing the mounting section, and
a heat dissipation fin is provided at an outer peripheral portion of any one of the upper plate, the lower plate, and the intermediate plate.

According to the heat pipe of the invention, the heat dissipation fin is formed continuously and integrally with the outer peripheral portion of the upper plate, the lower plate, or the intermediate plate.

According to the heat pipe of the invention,
heat dissipation fins are provided at outer peripheral portions of the upper plate, the lower plate, and the intermediate plate, respectively, and
the heat dissipation fin of the upper plate, the heat dissipation fin of the lower plate, and the heat dissipation fin of the intermediate plate do not contact one another when the upper plate, the lower plate, and the intermediate plate are stacked together.

According to the heat pipe of the invention, the heat dissipation fin is bent in parallel or at an arbitrary angle with respect to an upper surface of the upper plate or a lower surface of the lower plate.

According to the heat pipe of the invention, a heat dissipation fin of the upper plate, a heat dissipation fin of the lower plate, and a heat dissipation fin of the intermediate plate are formed in a formation pattern in such a manner as not to contact one another.

According to the heat pipe of the invention,
a plurality of through holes are formed in the intermediate plate, and displaced to one another for every adjoining intermediate plates, and
the capillary flow path is so formed as to incline in an oblique direction from a vertical direction with a direction between the upper plate and the lower plate taken as the vertical direction.

According to the heat pipe of the invention, the cooling unit main body and the device to be cooled and mounted thereon are formed as a single piece.

According to the heat pipe of the invention, the device to be cooled is a light emitting device.

### EFFECT OF THE INVENTION

According to the invention, there is provided a small size heat pipe which facilitates conduction of heat from a cooling target device to a refrigerant more, surely continues cooling the cooling target device, thereby maintaining the operation state of the cooling target device stable.

Moreover, there is provided a small size heat pipe which can improve the heat dissipation effect in comparison with conventional heat pipes.

### BRIEF DESCRIPTION OF THE DRAWINGS

FIG. 1 is a perspective view showing the general structure of a light emitting device according to a first embodiment of the invention;
FIG. 2 is a cross-sectional view showing cross-sectional structures of the light emitting device along lines A-A' and B-B' in FIG. 1;
FIG. 3 is a cross sectional view showing a detailed cross-sectional structure of a concave portion;
FIG. 4 is an exploded perspective view showing an upper plate, first pattern intermediate plates, second pattern intermediate plates and a lower plate which constitute a heat pipe according to the first embodiment;
FIG. 5 is a perspective view showing the outline structure of the heat pipe;
FIG. 6 is a schematic diagram showing the way how the fist pattern intermediate plate and the second pattern intermediate plate are stacked on the lower plate, and the way how capillary flow paths are formed with through holes being displaced to one another;
FIG. 7 is a schematic diagram showing a first way (1) how the capillary flow paths and vapor diffusion flow paths are formed;
FIG. 8 is a schematic diagram showing the way how minute capillary flow paths are formed with the through holes displaced to one another;
FIG. 9 is a schematic diagram showing a second way (2) how the capillary flow paths and the vapor diffusion flow paths are formed;
FIG. 10 is a schematic diagram showing the planar structure and side sectional structure of the heat pipe;
FIG. 11 is a schematic diagram showing a first example of a method for manufacturing the heat pipe;
FIG. 12 is a schematic diagram showing a second example of a method for manufacturing the heat pipe;
FIG. 13 is a schematic diagram showing a sealing process of deforming a sealing member;
FIG. 14 is a schematic diagram showing the planar structure of a refrigerant charging hole;
FIG. 15 is a detailed cross-sectional view showing refrigerant circulating phenomenon;
FIG. 16 is a schematic diagram showing refrigerant circulating phenomenon in an intermediate plate where a plurality of vapor-diffusion-flow-path formation holes are formed radially;
FIG. 17 is an exploded perspective view showing an upper plate, first pattern intermediate plates, second pattern intermediate plates, and a lower plate which constitute a heat pipe of a second embodiment;
FIG. 18 is a perspective view showing an example where heat dissipation fins are formed which are bent perpendicularly with respect to the surface of a cooling unit main body;
FIG. 19 is a schematic diagram showing the planar structure and side sectional structure of the cooling unit main body having the heat dissipation fins bent perpendicularly;
FIG. 20 is a perspective view showing the general structure of a light emitting device according to a fourth embodiment;
FIG. 21 is an exploded perspective view showing an upper plate, fin-provided intermediate plates, fin-less intermediate plates, and a lower plate which constitute a heat pipe of the fourth embodiment;
FIG. 22 is a cross-sectional view showing the cross-sectional structure of the light emitting device of the fourth embodiment;
FIG. 23 is a cross-sectional view showing the cross-sectional structure of a heat pipe according to a fifth embodiment;
FIG. 24 is an exploded perspective view showing an upper plate, fin-provided intermediate plates, and a lower plate which constitute the heat pipe of the fifth embodiment;
FIG. 25 is a cross-sectional view showing the cross-sectional structure of a light emitting device according to a sixth embodiment;
FIG. 26 is a schematic diagram showing the planar structure and side sectional structure of a heat pipe;
FIG. 27 is a schematic diagram showing the planar structure of a first pattern intermediate plate;
FIG. 28 shows a result of thermographic observation indicating the temperature distribution of a heat pipe with which heat dissipation fins are formed integrally, and graphs representing the temperature distribution;
FIG. 29 shows a result of thermographic observation indicating the temperature distribution of a copper-made heat spreader having heat dissipation fins separately formed, and graphs representing the temperature distribution;
FIG. 30 shows a result of thermographic observation indicating the temperature distribution of a heat pipe provided with no heat dissipation fin, and graphs representing the temperature distribution;
FIG. 31 is a diagram showing the structure of a light emitting device disclosed in patent literature 1;
FIG. 32 is a diagram showing the structure of a light emitting device disclosed in patent literature 2; and
FIG. 33 is a diagram showing the structure of a light emitting device disclosed in patent literature 3.

### BEST MODE FOR CARRYING OUT THE INVENTION

A heat pipe of the invention comprises a cooling unit main body that has a mounting section which mounts a device to be cooled on either a tabular upper plate or a tabular lower plate, and one or a plurality of tabular intermediate plates sandwiched between the upper plate and the lower plate. For example, when the mounting section is provided on the upper plate, the heat pipe is provided with a concave portion, which is formed in such a manner as to be thinner than other areas of the upper plate, at the upper outside surface of the upper plate, and the cooling target device is mounted in the concave portion.

The concave portion is formed in various shapes, such as rectangle, and circle, and it is preferable that the concave portion should be formed in the same shape as that of the cooling target device and have a selected size for only housing the cooling target device. As mentioned, according to the heat pipe, the thickness of the area of the concave portion is so formed as to be thinner than other areas of a mounting section, and, mounting the cooling target device in the concave portion facilitates conduction of heat, generated by the cooling target device, to a refrigerant in the cooling unit main body by what corresponds to the thinning of the thickness of the concave portion.

Inside the cooling unit main body, one or a plurality of intermediate plates form flow paths (hereinafter called vapor diffusion flow paths) for diffusing a vapor toward the peripheral portion side of the cooling unit main body, and another type of flow paths (hereinafter called capillary flow paths) for causing the refrigerant to flow in a vertical direction and an oblique direction by capillary phenomenon when a direction between the upper plate and the lower plate is taken as the vertical direction. The upper plate has recessed grooves in a grid pattern or the like formed at the lower inside surface thereof, while the lower plate has recessed grooves in a grid pattern formed at the upper inside surface thereof, and the vapor diffusion flow paths and the capillary flow paths are communicated with one another through the concave portion (hereinafter, upper-plate-inside surface groove portion) formed at the lower inside surface of the upper plate and the concave portion (hereinafter, lower-plate-inside surface groove portion) formed at the upper inside surface of the lower plate.

Note that the upper-plate-inside surface groove portion and the lower-plate-inside surface groove portion are partitioned by projecting poles in the following embodiments, but may be formed in other patterns like a mesh pattern. In response to such patterns, the projecting poles are formed in such a manner as to have a transverse section formed in a square, circular, elliptical, polygonal, or a star shape.

The heat pipe is structured in such a way that the capillary flow paths formed in the intermediate plate cause capillary phenomenon in the cooling unit main body, and the refrigerant is led to the vicinity of the concave portion formed at the mounting section by the capillary phenomenon.

When this causes heat generated due to the operation of the cooling target device to be transferred to the refrigerant in the cooling unit main body, the cooling target device is cooled by latent heat at a time when the refrigerant vaporizes, the vapor of the refrigerant is diffused to the peripheral portion of the cooling unit main body through the vapor diffusion flow paths, and condenses at the peripheral portion. The refrigerant which has condensed and liquefied enters into the capillary flow paths through the upper-plate-inside surface groove portion and the lower-plate-inside surface groove portion by capillary phenomenon, are pulled by negative pressure originating from evaporation occurred at an area (hereinafter, simply called concave portion opposite region) which is formed in the same shape as that of the area of the concave portion of the cooling unit main body and is opposite to the concave portion, returns to the concave portion opposite region, and absorbs heat generated at the cooling target device by evaporative latent heat. Successively repeating the circulation of such a refrigerant causes more effective thermal diffusion in comparison with conventional technologies.

According to the heat pipe of the invention, heat from the cooling target device is drawn not only from the bottom surface of the concave portion but also from the periphery walls of the concave portion, by mounting the cooling target device in the concave portion, and this facilitates heat conduction from the upper plate to the refrigerant more. Accordingly, because the heat pipe can efficiently dissipate heat conducted from the upper plate by successive circulation of the refrigerant through the vapor diffusion flow paths and the capillary flow paths, heat from the cooling target device does not remain inside the concave portion, so that the operation state of the cooling target device does not become unstable by heat. As a result, the cooling target device does not perform false operation by heat, and can operate continuously and stably.

Preferable material of the upper plate, the lower plate and the intermediate plate which constitute the cooling unit main body is copper, copper alloy, aluminum, aluminum alloy, iron, iron alloy, stainless, gold, silver or the like which has a high thermal conductivity, and forming the cooling unit main body from the foregoing material makes it possible to finish the lower plate or the like of the cooling unit main body as a flat surface with good precision. For thinning of the heat pipe, it is preferable that the thicknesses of the upper plate and lower plate should be within a range from 500 to 2000 µm, and the depths of the upper-plate-inside surface groove portion and the lower-plate-inside surface groove portion (i.e., the heights of projecting poles) are within a range from 100 to 1000 µm. It is preferable that the thickness of the intermediate plate should be within a range from 50 to 500 µm. A preferable refrigerant is water (pure water, distilled water, or the like), ethanol, methanol, acetone, or the like.

In the concave portion, conduction of heat generated from the cooling target device to the refrigerant in the heat pipe is facilitated by what corresponds to the thinning of the thickness, and a fluid circulation property is improved by what corresponds to such facilitation, thereby cooling the cooling target device further rapidly. The heat pipe can be thin by selecting the depth of the concave portion in such a way that the upper part of the cooling target device does not protrude from the upper plate or slightly protrude therefrom when the cooling target device is mounted in.

The mounting section itself may be the concave portion, and concave portions may be provided at various portions of the mounting section. The concave portion is provided at the central portion of the upper plate, but may be formed in such a manner as to be displaced from the central portion, and the number of concave portions to be provided may be one or more. When a plurality of concave portions are provided, they may be formed in such a manner as to be linearly aligned in a line, or aligned circularly, squarely. The heat pipe has the vapor diffusion flow paths formed radially toward the peripheral portion with the concave portion being the center in the cooling unit main body, and the capillary flow paths formed in the concave portion opposite region, so that the refrigerant is led to the vicinity of the concave portion by capillary phenomenon caused by the capillary flow paths, thereby cooling all cooling target devices efficiently.

When the vapor diffusion flow paths are formed radially at portions including, for example, all corners of the four corners, toward the peripheral portion, the heat pipe can efficiently dissipate heat of the cooling target device using the cooling unit main body entirely, and enhance the heat conduction effect, so that a most appropriate heat pipe is provided. The vapor diffusion flow path may be formed in a band-like shape, trapezoidal shape, or in such a shape that the width becomes large or narrow from the center toward the peripheral portion. The vapor diffusion flow path may be formed in various other shapes.

When a plurality of intermediate plates are provided, overlapped holes for the vapor diffusion flow paths may be completely overlapped with one another, or may be displaced in a width direction. When there is one intermediate plate used, the holes for the vapor diffusion flow paths serves as vapor diffusion flow paths. In the embodiments to be discussed later, the intermediate plates are overlapped in such a way that the holes for the vapor diffusion flow paths are not displaced in the width direction.

When the plurality of intermediate plates are used, by overlapping the plurality of intermediate plates, overlapped through holes form the capillary flow paths communicating with the vapor diffusion flow paths. The through holes of each intermediate plate may be formed in different patterns for each intermediate plate, and may be formed in the same pattern for all intermediate plates. When there is one intermediate plate used, the through holes serve as the capillary flow paths.

That is, the intermediate plates may be provided between the upper plate and lower plate in such a way that the positions, shapes and sizes of the through holes of the respective intermediate plates coincide to thereby constitute capillary flow paths having the same position, shape and size as the through hole of each intermediate plate. In this case, the through hole or the resultant capillary flow path may have a rectangular shape (e.g., square or oblong shape), of which the corners may be rounded. Although it is to be of a rectangular shape fundamentally, a part or whole side thereof (peripheral inside surface of the capillary flow path) may be corrugated or wrinkled so as to enlarge a surface area thereof, because a cooling effect is enhanced if the peripheral inside surface area of the capillary flow path is large. Alternatively, the capillary flow path may take a hexagonal, circular or elliptical shape.

However, to form the capillary flow path with a smaller cross-sectional area in the horizontal direction orthogonal to the vertical direction with a direction between the upper plate and the lower plate taken as the vertical direction, the plural intermediate plates may be suitably displaced from the positions where the respective through holes are precisely aligned with one another so as to be only partially overlapped, thereby enabling the substantive cross-sectional area of the capillary flow path to be made small as compared with the cross-sectional area of the through hole of each intermediate plate.

Specifically, when the two intermediate plates are used, it is possible to reduce the substantive cross-sectional area of the capillary flow path to about 1/2 of that of the through hole of each intermediate plate, by displacing the respective intermediate plates by a half pitch of an arrangement pitch in a predetermined direction (e.g., lateral direction, (one side direction when the through hole is formed in rectangular shape)), with the size, shape and arrangement pitch of each through hole being kept the same. Furthermore, if the positions of the through holes of the two intermediate plates are also displaced in a direction intersecting with the foregoing side direction (e.g., longitudinal direction. (another side direction orthogonal to one side direction)), the substantial cross-sectional area of the capillary flow path can be reduced to about 1/4 of that of the through hole of each intermediate plate. When the through holes are displaced in the respective intermediate plates, then the capillary flow paths are formed such that the refrigerant flows not only in the vertical direction but also in the oblique direction inclined from the vertical direction.

Because such capillary flow paths are formed in the concave portion opposite region, the heat pipe can employ a structure such that the refrigerant is likely to be collected in the concave portion opposite region by capillary phenomenon caused by the capillary flow paths, so that even if the cooling target device is disposed on the upper part of the cooling unit main body, the refrigerant is surely led to the vicinity of the lower part of the concave portion regardless of the gravity, thereby surely cooling the cooling target device mounted in the concave portion regardless of the state how the heat pipe is disposed.

The capillary flow paths may be formed not only in the concave portion opposite region, but also in an area opposite to the mounting section (hereinafter called mounting section opposite region) entirely. In this case, a large amount of refrigerant can be surely led to the mounting section opposite region which is wider than the concave portion opposite region, thereby surely cooling the cooling target device from the peripheral portion thereof.

The through holes of the intermediate plates form the capillary flow paths, but fiber members may be filled in the hollows of the through holes having a predetermined size for example to form fiber areas, and the fiber members may be gathered at a high density to thereby cause capillary phenomenon.

Because the heat pipe is structured in such a way that the cooling unit main body and the cooling target device mounted on the cooling unit main body adhere tightly to each other, heat is quickly transferred to the cooling unit main body from the cooling target device, thereby enhancing the cooling effect. The size of the heat pipe can be appropriately determined in accordance with the heating value of the cooling target device, and when the heating value thereof is small, the size of the heat pipe is reduced for miniaturization.

When a light emitting device is used as the cooling target device, light from the light emitting device is reflected by the periphery walls and bottom surface of the concave portion and is undergone spherical reflection, thereby emitting the light in a desired direction efficiently.

When the periphery walls of the concave portion have an arbitrary inclination angle less than or equal to 90 degrees, light emitted from the light emitting device can be undergone spherical reflection in a desired direction. When a portion between the periphery wall and bottom surface of the concave portion is tapered according to the necessity, light emitted from the light emitting device can reflect in a desired direction. Various light emitting devices which generate heat in emitting light, such as LEDs, and laser diodes can be used as the light emitting device.

More lights emitted from the light emitting device can reflect the concave portion by selecting the depth of the concave portion in such a way that the upper part of the light emitting device does not protrude from the upper plate or slightly protrudes therefrom when the light emitting device is mounted in.

The heat pipe may have a light reflection film formed on the surfaces of the concave portion by nickel plating or metal deposition using a material which has a high reflectivity, and mounting the light emitting device in such a concave portion makes it possible to cool the light emitting device and to cause light emitted from the light emitting device to reflect the periphery walls and the bottom surface of the concave portion, so that scattering of light emitted from the light emitting device is prevented, and the light is further efficiently undergone spherical reflection in a desired direction. When the light reflection film has a color like white, light emitted from the light emitting device can be further reflected.

Next, an explanation will be given of a heat pipe which has heat dissipation fins provided at any of an upper plate, a lower plate, and one or a plurality of intermediate plates sandwiched between the upper plate and the lower plate.

The heat pipe dissipates heat from the cooling target device by the above-described successive circulation of the refrigerant through the vapor diffusion flow paths and the capillary flow paths, and causes heat diffused to the peripheral portion of the cooling unit main body by the refrigerant to be transferred to the heat dissipation fins, and causes the heat to be transferred to outside air having a larger heat capacity through the heat dissipation fins, thereby further enhancing the heat dissipation effect.

According to such a heat pipe, by forming the heat dissipation fins continuously and integrally at the outer portions of the upper plate, the lower plate and one or a plurality of intermediate plates without providing an adhesion layer, there becomes no large thermal resistance between the cooling unit main body and the heat dissipation fins and conduction of heat diffused to the peripheral portion of the cooling unit main body through the refrigerant which flows through the vapor diffusion flow paths is facilitated, the temperature changes in the cooling unit main body and the heat dissipation fins become small, thereby further enhancing the heat dissipation effect.

The heat dissipation fins may be provided at all of the upper plate, the lower plate, and one or a plurality of intermediate plates, or provided at any one of the upper plate, the lower plate, and one or a plurality of intermediate plates. The heat dissipation fin may be formed in a band-like shape, rectangular shape, oblong shape, triangular shape, and various shapes other than those. That is, the shapes and number of the heat dissipation fins are selected in accordance with a place where the heat pipe is disposed and the heating value of the cooling target device mounted on the heat pipe.

In this case, when one or a plurality of intermediate plates are sandwiched between the upper plate and the lower plate and those plates are integrated together, the heat dissipation fins are formed at adjoining upper plate and intermediate plate, lower plate and intermediate plate, and two intermediate plates in such a manner as to be displaced to one another, so that the heat dissipation fins do not contact one another.

For example, when the four intermediate plates are stacked on the lower plate, the upper plate is stacked on the top intermediate plate and those plates are integrated together, the heat dissipation fins of the respective upper plate, lower plate and plural intermediate plates are formed in the same shape, the same number of heat dissipation fins are provided at the same locations in the lower plate, the second intermediate plate, and the fourth intermediate plate. On the other hand, for the first intermediate plate, the third intermediate plate and the upper plate, the heat dissipation fins are provided at locations shifted from the locations of the heat dissipation fins of a plate under those plates. By constituting the heat pipe in such a way that the same number of heat dissipation fins are provided at the same locations alternately, the heat dissipation fins of adjoining plates in the lower plate, the intermediate plates and the upper plate do not contact one another.

That is, according to the heat pipe, first pattern intermediate plates and second pattern intermediate plates having different heat-dissipation-fin formation patterns are successively and alternately stacked, the heat dissipation fins do not contact one another even if the heat pipe is formed thin, the surface areas of the individual heat dissipation fins can be taken widely, thereby further enhancing the heat dissipation effect.

The aforementioned structure of the heat dissipation fin is just an example, and as long as adjoining heat dissipation fins do not overlap each other, intermediate plates having the heat dissipation fins formed in the predetermined shape and at all of the outer peripheral portions, and intermediate plates having no heat dissipation fin may be alternately stacked on for example, and in this case, adjoining heat dissipation fins do not overlap while thinning of the heat pipe is achieved.

Those heat dissipation fins may be provided so as to be in parallel with the surface of the cooling unit main body, bent perpendicularly with respect to the surface of the cooling unit main body at right angle, or bent at an arbitrary angle within a range between a plane parallel to the surface of the cooling unit main body and a plane orthogonal thereto. When such a structure is employed, the heat dissipation fins do not contact one another, a necessary cooling performance is maintained, and a space in the width direction is reduced by bending the heat dissipation fins, thereby realizing the heat pipe which has both a desired size and a maximum cooling performance.

Regarding the positions where the heat dissipation fins are bent at the upper plate, lower plate, and intermediate plates, the heat dissipation fins become not to contact one another by displacing those positions successively from the first position which is integral with each plate to the leading end, from the lower plate to the upper plate through the intermediate plates in this order. The heat dissipation fin may be bent at right angle, curved having a smooth curve line, and in any shapes other than those.

When such a heat pipe is provided with a concave portion to mount a light emitting device, or provided with the light emitting device directly on the upper plate without the concave portion and used as a heat pipe for the light emitting device, the heat dissipation fins provided at the outer peripheral portion of the upper plate are bent at an arbitrary angle in such a manner as to protrude from the top surface of the upper plate, so that light emitted from the light emitting device can reflect the bent heat dissipation fins, and scattering of the light emitted from the light emitting device is prevented, thereby applying the light in a desired direction efficiently.

### (1) Embodiments

### (First Embodiment)

The present invention will be explained based on embodiments.

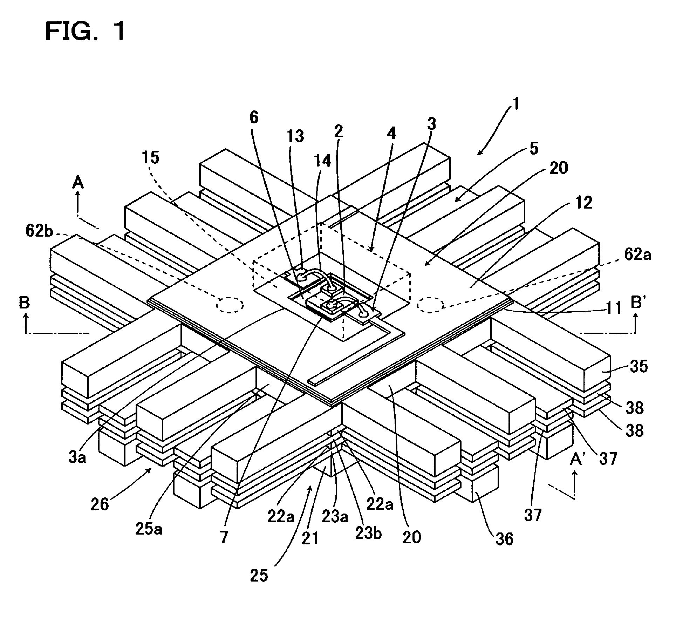

FIG. 1 shows the outline structure of a light emitting device 1 according to a first embodiment, and the light emitting device 1 has a light emitting unit 4 comprising an LED chip 2 and an LED substrate 3, and a heat pipe 5 of the invention, the light emitting unit 4 is provided in a mounting section 3a of the heat pipe 5.

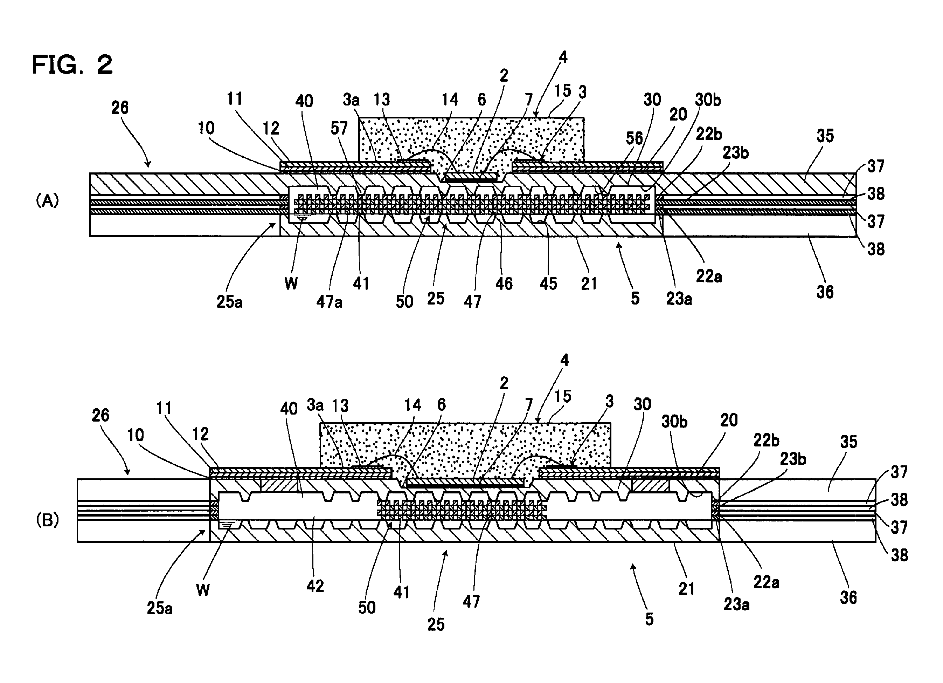

As shown in FIG. 2(A) which is a cross-sectional view along a line A-A' in FIG. 1, the heat pipe 5 is provided with a concave portion 6 at the center of the upper surface which is a part of the area of the mounting section 3a, the LED chip 2 is mounted in the concave portion 6 through a die bond 7, and the LED substrate 3 is provided at an area other than the concave portion 6 of the mounting section 3a. The LED substrate 3 has an insulating layer 11 bonded to the upper surface of the heat pipe 5 through an adhesion layer 10, and a wiring circuit board 12 provided on the insulating layer 11.

The light emitting unit 4 has the LED chip 2 electrically connected to electrodes 13 provided on the wiring circuit board 12 through wirings 14, and thus power is supplied to the LED chip 2. The light emitting unit 4 has the LED chip 2, the electrodes 13, and the wirings 14 sealed by a transparent resin 15. In the embodiment, the LED chip 2 as a light emitting device is formed in a rectangular shape having a size of 1 mm by 1 mm or so, is high brightness, has a large heating value, and is formed so as to be a single piece with the heat pipe 5 together with the wiring circuit board 12.

The concave portion 6 in which the LED chip 2 is mounted has an outer periphery formed along the contour of the LED chip 2, and is formed as to be slightly larger than the contour of the LED chip 2, thereby housing the LED chip 2 only in a concaved space. In the embodiment, the concave portion 6 is formed to have a rectangular contour along the contour of the rectangular LED chip 2.

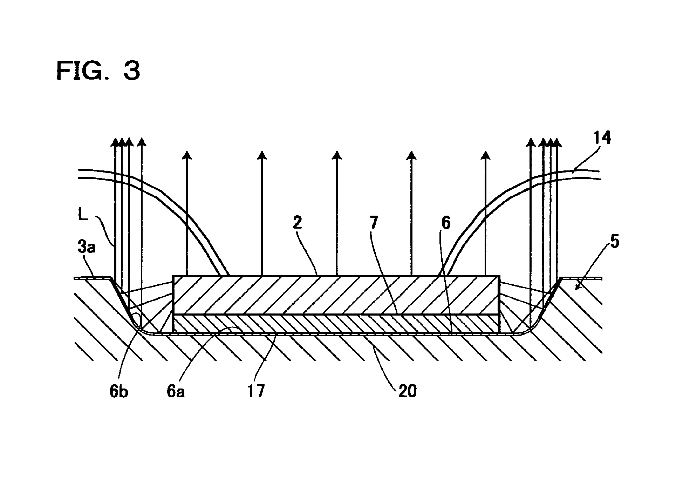

As illustrated in FIG. 3 which is an enlarged cross-sectional view of the concave portion 6, the concave portion 6 has a bottom surface 6a of a concaved space formed along the bottom shape of the LED chip 2, and by mounting the LED chip 2 on the bottom surface 6a, the LED chip 2 adheres tightly to the bottom surface 6a, and the upper end surface of the LED chip 2 can be supported as to be parallel to the bottom surface of the heat pipe 5. Therefore, a direction in which the upper end surface of the LED chip 2 faces can be adjusted by appropriately adjusting the mounting state of the chip on the bottom surface of the heat pipe 5.

The depth of the concave portion 6 is selected in such a way that the upper end surface of the LED chip 2 doe not protrude from the heat pipe 5, and a peripheral wall 6b of the concaved space is formed so as to surround the outer periphery of the LED chip 2. In addition to this structure, the concave portion 6 has a light reflective film 17 which is formed on the peripheral wall 6b and the bottom surface 6a and is formed of a material having a high reflectivity like nickel by a film formation process, such as plating and metal deposition, and lights L emitted from the LED chip 2 toward the concave portion 6 can be reflected effectively.

In addition to such a structure, as shown in FIG. 2(A), the concave portion 6 has a thinner thickness than other portions in the upper plate 20, so that heat generated from the LED chip 2 is rapidly transferred to a refrigerant W in the heat pipe 5 by what corresponds to the thinning of the concave portion.

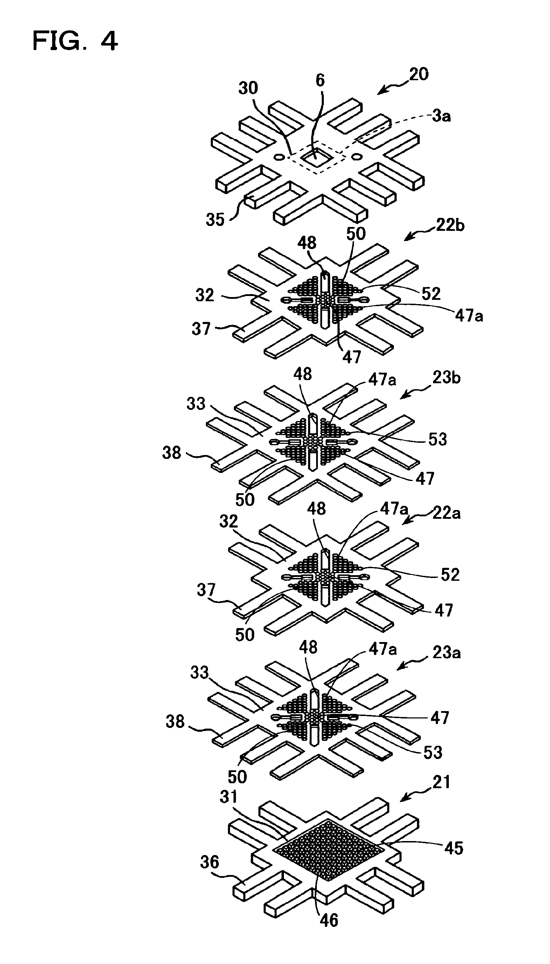

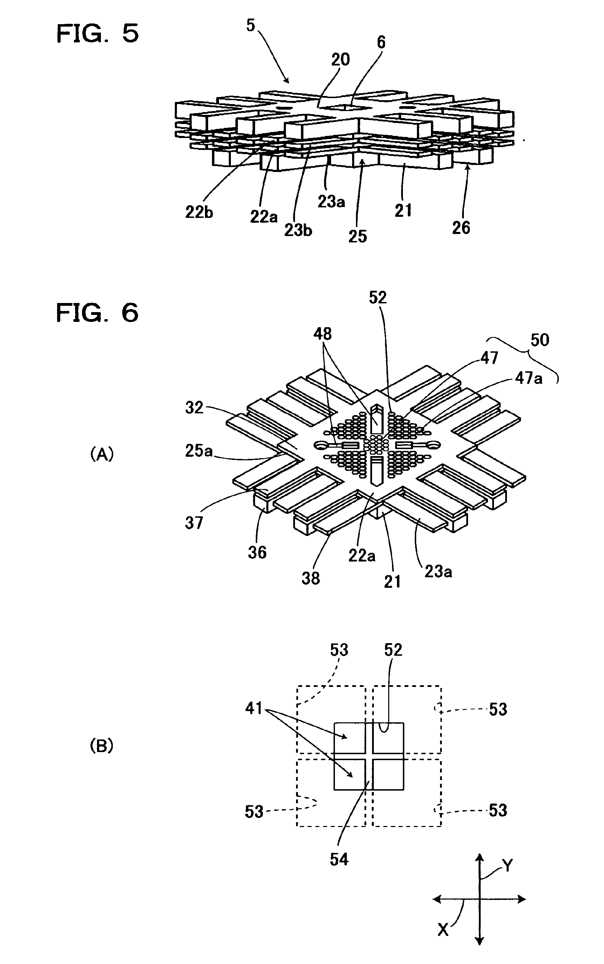

As shown in FIG. 4, the heat pipe 5 for cooling the LED chip 2 comprises an upper plate 20, a lower plate 21, first pattern intermediate plates 22a, 22b, and second pattern intermediate plates 23a, 23b, the second pattern intermediate plate 23a, the first pattern intermediate plate 22a, the second pattern intermediate plate 23b and the first pattern intermediate plate 22b are stacked on the lower plate 21 in this order, the upper plate 20 is stacked on the first pattern intermediate plate 22b, those plates are positioned based on non-illustrated positioning holes and directly joined together, thereby forming an integrated structure shown in FIG. 5.

Note that the words "directly joined" means applying a pressure and performing a heat treatment with first and second surfaces to be joined being adhered tightly to each other, thereby causing atoms to rigidly join one another by atomic force applied between the first and second surfaces, and this enables integration of the first and second surfaces without using an adhesive or the like. The upper plate 20, the lower plate 21, the first pattern intermediate plates 22a, 22b, and the second pattern intermediate plates 23a, 23b are all made of high thermal conductive materials having a high thermal conductivity like copper.

As shown in FIG. 2(A), the heat pipe 5 comprises a cooling unit main body 25 formed in a short rectangular column like shape, and a heat dissipation fin array 26 provided at an outer peripheral portion 25a of the cooling unit main body 25, and extending in a direction horizontal to the upper surface of the cooling unit main body 25. In the embodiment, the size of the cooling unit main body 25 is selected to 5 mm by 5 mm or so with respect to the LED chip 2 of 1 mm by 1 mm, and the size of the cooling unit main body 25 including the heat dissipation fin array 26 provided at the outer peripheral portion 25 is selected to approximately 10 mm by 10 mm or so.

In practice, the cooling unit main body 25 comprises a main body 30 of the upper plate 20, a main body 31 of the lower plate 31, main bodies 32 of the first pattern intermediate plates 22a, 22b, and main bodies 33 of the second pattern intermediate plates 23a, 23b. The heat dissipation fin array 26 comprises a plurality of heat dissipation fins 35 formed integral with the outer peripheral portion 25a of the main body 30 of the upper plate 20, a plurality of heat dissipation fins 36 formed integral with the outer peripheral portion 25a of the main body 31 of the lower plate 21, a plurality of heat dissipation fins 37 formed integral with the outer peripheral portion 25a of the main bodies 32 of the fist pattern intermediate plates 22a, 22b, and a plurality of heat dissipation fins 38 formed integral with the outer peripheral portion 25a of the main bodies 33 of the second pattern intermediate plates 23a, 23b.

As shown in FIG. 2(A), in a sealed space 40 of the cooling unit main body 25, by stacking the main bodies 32 of the first pattern intermediate plates 22a, 22b and the main bodies 33 of the second pattern intermediate plates 23a, 23b sequentially and alternately, minute capillary flow paths 41 shown in FIG. 2(A) and vapor diffusion flow paths 42 radially extending from the center toward the peripheral portion as shown in FIG. 2(B), which is a cross-sectional view along a line B-B' in FIG. 1, are formed. FIG. 2(A) is a cross-sectional view at a part of an area where the interior of the cooling unit main body 25 is filled with the capillary flow paths 41, and FIG. 2(B) is a cross-sectional view at a part of an area where the interior of the cooling unit main body 25 is partitioned by the capillary flow paths 41 and the vapor diffusion flow paths 42. A predetermined amount of refrigerant W comprising water is filled in the sealed space 40 of the cooling unit main body 25 under a reduced pressure atmosphere, and this lowers the boiling point of the refrigerant W, and causes the refrigerant W to vaporize due to little heat from the LED chip 2 and to circulate the vapor through the vapor diffusion flow paths 42 and the capillary flow paths 41.

In practice, according to the heat pipe 5, heat from the LED chip 2 is delivered to the concave portion 6, the refrigerant W is heated and vaporizes from the concave portion 6, the vapor diffuses to the peripheral portion of the cooling unit main body 25 through the plurality of (in the embodiment, four) vapor diffusion flow paths 42 which extend from a concave portion opposite region 47 to directions between diagonal corners, a grid-like upper-plate-inside surface groove portion 56 of the upper plate 20 having a predetermined depth, and a grid-like lower-plate-inside surface groove portion 45 of the lower plate 21 having a predetermined depth. In the heat pipe 5, the refrigerant W is undergone heat diffusion condensation and liquefied at the peripheral portion, and the liquefied refrigerant W returns to the LED chip 2 side by capillary phenomenon in the capillary flow paths 41, and circulating phenomenon caused by such a refrigerant W is successively repeated.

According to the heat pipe 5, even though the LED chip 6 is mounted in the concave portion 6 having a thinner thickness than other portions of the upper plate 20 and large amount of heat is drawn from the LED chip 2, heat is conducted away from the LED chip 2 by latent heat at a time when the refrigerant W vaporizes and is dissipated through the entire surfaces of the upper plate 20 and the lower plate 21 and the heat dissipation fin array 26 because the refrigerant W can be surely returned to the LED chip 2 side by capillary phenomenon caused by the capillary flow paths 41, so that the LED chip 2 is surely cooled down. Next, an explanation will be given of the respective structures of the upper plate 20, the lower plate 21, the first pattern intermediate plates 22a, 22b, and the second pattern intermediate plates 23a, 23b which constitute the heat pipe 5 in detail. As shown in FIG. 4, in the case of this embodiment, the lower plate 21 has the lower-plate-inside surface groove portion 45 formed on the upper inside surface of the almost quadrate main body 31 other than the frame-shaped peripheral portion which serves as the contour, and projecting poles 46 each having a planer leading end are provided in the respective area partitioned by the lower-plate-inside surface groove portion 45.

In addition, the main body 31 of the lower plate 21 has the rectangular heat dissipation fins 36 each having a predetermined width at the outer peripheral portion 25a in such a pattern that each side has two heat dissipation fins formed integrally therewith and spaced away at a predetermined clearance (eight fins, total) (hereinafter, this pattern is called first fin formation pattern).

The main bodies 32 of the first pattern intermediate plates 22a, 22b and the main bodies 33 of the second pattern intermediate plates 23a, 23b are formed in an almost square shape which is the same as that of the main body 31 of the lower plate 21, and has vapor-diffusion-flow-path formation holes 48 and capillary formation regions 50. The capillary formation region 50 has the rectangular concave portion opposite region 47 which faces the concave portion 6 of the upper plate 20 when the main body 30 of the upper plate 20 is stacked on the main bodies 32, 33, and an area 47a which presents between the adjoining vapor-diffusion-flow-path formation holes 48 other than the concave portion opposite region 47. The vapor-diffusion-flow-path formation holes 48 (slit) each formed in a band-like shape radially extend toward the four corners other than the concave portion opposite region 47.

Because the first pattern intermediate plates 22a, 22b have the same size and shape, an explanation will be given of only the first pattern intermediate plate 22a. A plurality of through holes 52 forming the capillary flow paths 41 are formed in the capillary formation regions 50 of the first pattern intermediate plate 22a in a first pattern to be discussed later. The capillary formation region 50 has a grid-like partition walls, and the areas partitioned by the partition walls serve as the through holes 52.

As shown in FIG. 6(B), the through holes 52 each formed in a rectangular shape are arranged regularly at predetermined clearances as a first pattern, and have sides parallel to the respective sides of the peripheral portion (i.e., contour) of the main body 32. In the embodiment, the width of the through hole 52 is selected to 280 µm or so, and the width of a partition wall is selected to 70 µm or so.

As shown in FIG. 6(A), the first pattern intermediate plate 22a has the rectangular heat dissipation fins 37 each of which has the same width as that of the heat dissipation fin 36 of the lower plate 21 and is formed integrally with the outer peripheral portion 25a of the main body 32 in such a way that each side has two fins (eight fins, total) in the same first fin formation pattern of the lower plate 21.

The second pattern intermediate plates 23a, 23b have the same size and are formed in the same shape. Hereinafter, only the second pattern intermediate plate 23a will be explained. A plurality of through holes 53 forming the capillary flow paths 41 are formed in the capillary formation regions of the second pattern intermediate plate 23a in a second pattern to be discussed later. As shown in FIG. 6(B), grid-like partition walls 54 are formed at the capillary formation region 50, and the individual areas partitioned by the partition walls 54 serve as the through holes 53. The through holes 53 each having a rectangular shape are arranged regularly at predetermined clearances as a second pattern like the first pattern, and have sides parallel to the respective sides of the peripheral portion (i.e., contour) of the main body 33. In addition, the through hole 53 is displaced to each through hole 52 of the first pattern intermediate plate 22a by a predetermined distance.

In the embodiment, for example, when the first pattern intermediate plate 22a and the second pattern intermediate plate 23a are positioned and stacked (FIG. 6(A)), as shown in FIG. 6(B), the through hole 52 of the first pattern intermediate plate 22a is displaced in an X direction of one side of the through hole 53 of the second pattern intermediate plate 23a by half of that side, and in a Y direction of the other side orthogonal to the one side by half of the other side. This allows a through hole 52 of the first pattern intermediate plate 22a to overlap the four adjoining through holes 53 of the second pattern intermediate plate 23a, thereby forming the four capillary flow paths 41. Accordingly, this enables lots of capillary flow paths 41, which are much smaller than the through holes 52, 53, partitioned minutely and have large surface areas, to be formed in the through hole 52.

In addition, as shown in FIG. 6(A), the second pattern intermediate plate 23a has the rectangular heat dissipation fins each having the same width as that of the heat dissipation fin 36 of the lower plate 21 formed integrally with the outer peripheral portion 25a of the main body 31 in a second fin formation pattern such that, unlike the first fin formation pattern, each side has three fins (twelve fins, total) at predetermined clearances.

As the second fin formation pattern, the heat dissipation fins 38 of the second pattern intermediate plate 23a are formed so as not to overlap the heat dissipation fins 36 of the lower plate 21 and the heat dissipation fins 37 of the first pattern intermediate plate 22a when the first pattern intermediate plates 22a, 22b and the second pattern intermediate plates 23a, 23b are stacked successively and alternately on the lower plate 21, the upper plate 20 is further stacked thereon, and those plates are positioned.

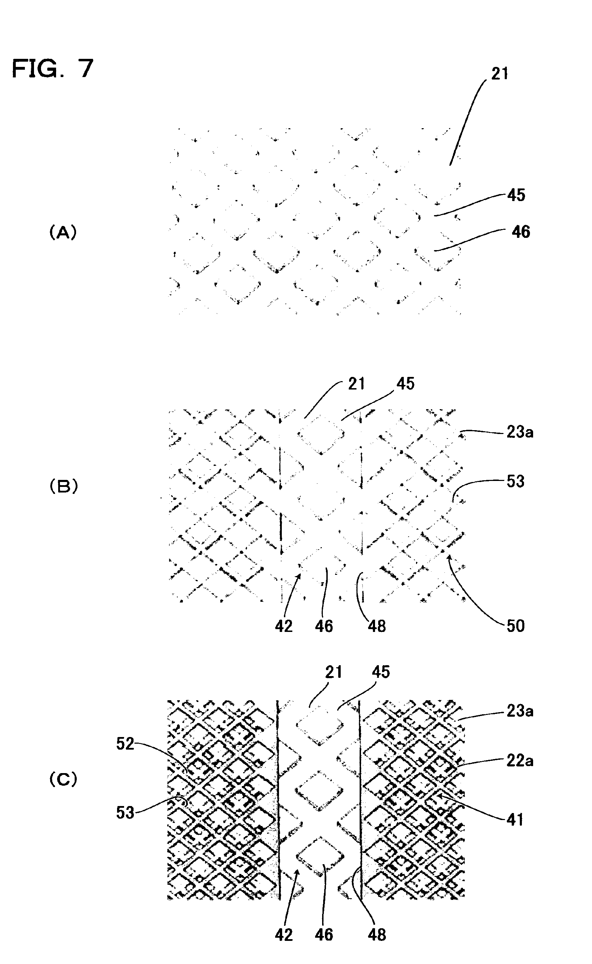

Next, the way how the capillary flow paths 41 and the vapor diffusion flow paths 42 are formed by the upper plate 20, the lower plate 21, the first pattern intermediate plates 22a, 22b, and the second pattern intermediate plates 23a, 23b with reference to FIGS. 7 to 9. As shown in FIGS. 7(A) and 7(B), the second pattern intermediate plate 23a is stacked on the lower plate 21 having the lower-plate-inside surface groove portion 45 at the upper inside surface, and as shown in FIG. 7(C), the first pattern intermediate plate 22a is stacked on the second pattern intermediate plate 23a. This causes the vapor-diffusion-flow-path formation holes 48 of the first and second intermediate plates 22a, 23a to directly overlap without being displaced, so that relatively large hollow spaces communicated with one another in a band-like shape and to be the vapor diffusion flow paths 42 are formed.

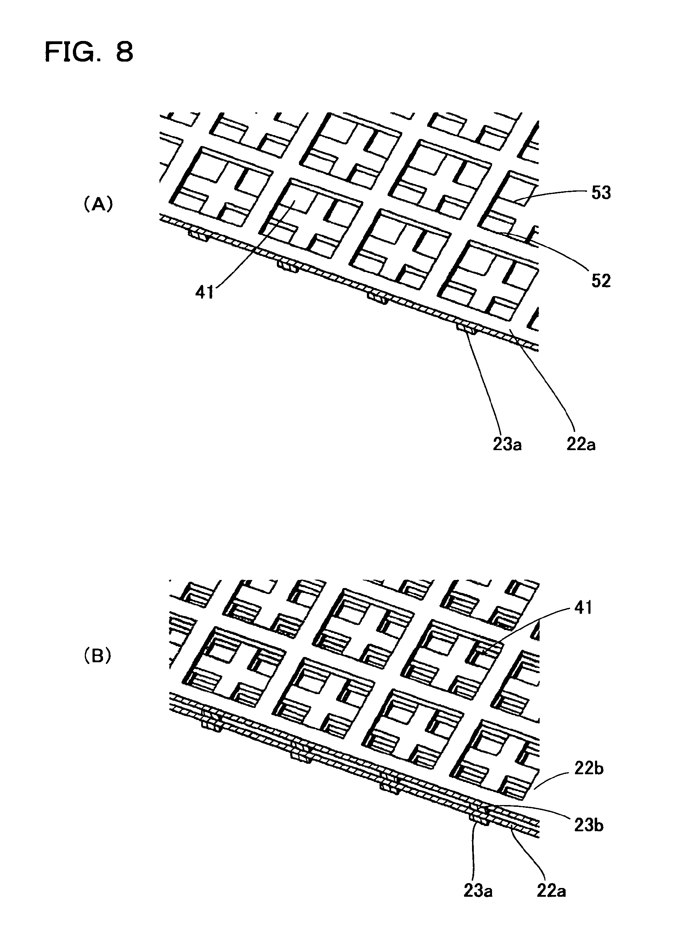

In the capillary formation regions 50 of the first and second pattern intermediate plates 22a, 23a, because the through hole 53 is displaced to the through hole 52 by half of a side for each side, the surface area of the hole is selected to be quarter or so of the surface areas of the through holes 52, 53. In practice, as shown in FIG. 8(A), the through hole is formed in a square shape whose one side is 280 µm, and a space between adjoining partition walls is selected to 350 µm, so that a space between the partition wall of the second pattern intermediate plate 23a and the partition wall of the first pattern intermediate plate 22a becomes 175 µm or so, and the plurality of minute capillary flow paths are formed.

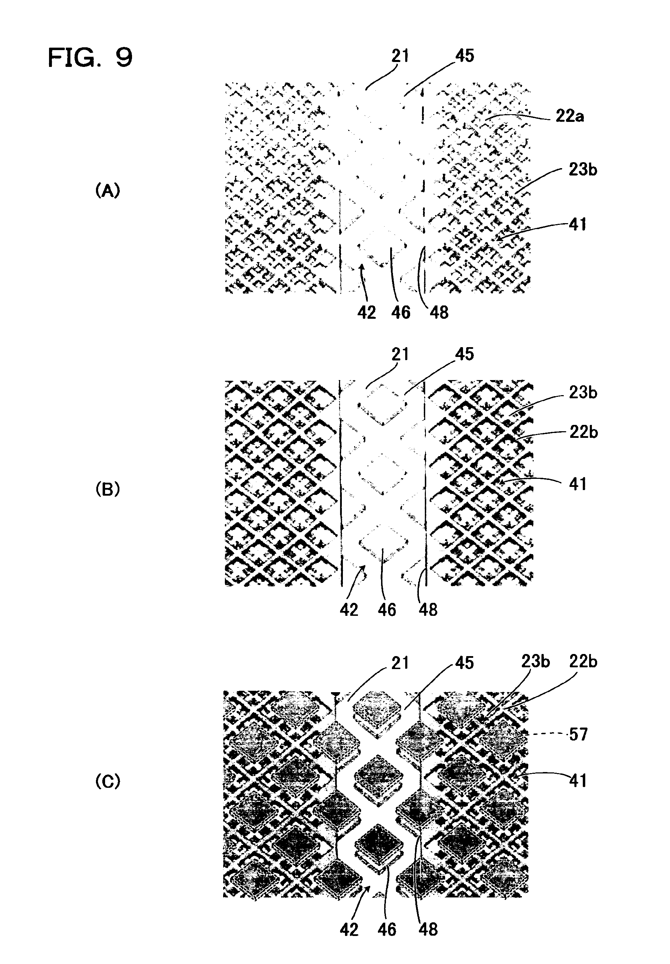

As shown in FIG. 9(A), the second pattern intermediate plate 23b is stacked on the first pattern intermediate plate 22a, and as shown in FIG. 9(B), the first pattern intermediate plate 22b is stacked on the second pattern intermediate plate 23b. This allows the first intermediate plates 22a, 22b and the second pattern intermediate plates 23a, 23b to overlap in such a way that all of the vapor-diffusion-flow-path formation holes 48 are not misaligned, and relatively large hollow areas communicated with one another in a band-like shape and to become the vapor diffusion flow paths 42 are formed (FIG. 9(A)).

The second pattern intermediate plate 23b and the first pattern intermediate plate 22b can form the plurality of minute capillary flow paths 41 like the first and second pattern intermediate plates 22a, 23a because the through holes 53 are displaced to the through holes 52 by half of a side for each side in the capillary formation regions 50 as mentioned above. As shown in FIG. 9(C), the upper plate 20 is stacked on the first pattern intermediate plate 22a and those plates are disposed in such a way that the projecting poles 57 of the upper-plate-inside surface groove portion 56 are aligned with the projecting poles 46 of the lower-plate-inside surface groove portion, and the vapor diffusion flow path 42 is communicated with the capillary flow path 41 through the upper-plate-inside surface groove portion 56 and the lower-plate-inside surface groove portion 45.

The upper plate 20 has the upper-plate-inside surface groove portion 56 formed at a lower inside surface 30b (FIG. 2(A) and 2(B)) of the main body 30 formed in an approximately square shape except the peripheral portion formed in a frame-like shape, and the projecting pole 57 having a flat leading end is provided at each area partitioned in grid pattern by the upper-plate-inside surface groove portion 56. In addition, the upper plate 20 has the rectangular heat dissipation fins 35 integrally each having the predetermined width and formed with the peripheral portion 25a in the second fin formation pattern such that each side has three fins at predetermined clearances (twelve fins, total), like the second pattern intermediate plates 23a, 23b.

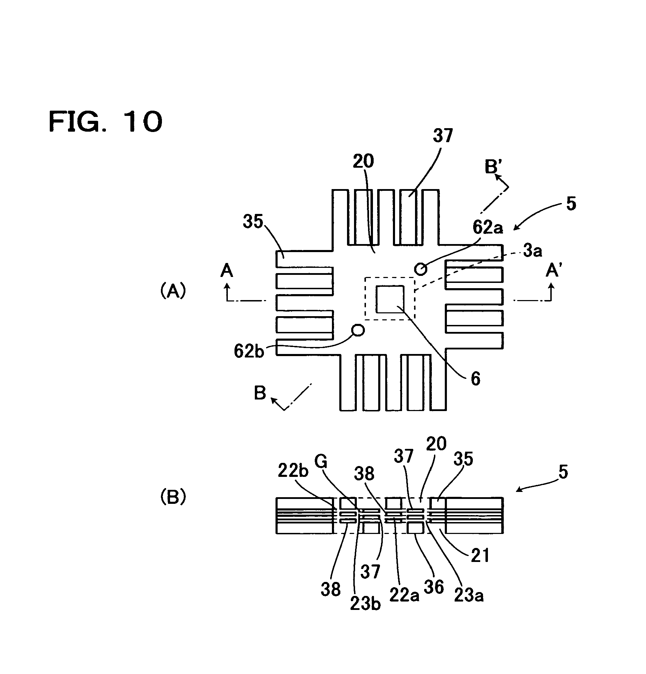

As shown in FIG. 10(A) and 10(B), when the first pattern intermediate plates 22a, 22b and the second pattern intermediate plates 23a, 23b are stacked successively and alternately on the lower plate 21, the upper plate 20 is stacked thereon and those plates are positioned, the heat pipe 5 is structured in such a way that the same number of heat dissipation fins are provided at the same positions for every plate, and the heat dissipation fins 35, 36, 37, 38 formed at the adjoining upper plate 20, first pattern intermediate plates 22a, 22b, second pattern intermediate plates 23a, 23b, and lower plate 21, respectively, do not overlap one another, and a space G is formed between two fins.

Accordingly, the heat pipe 5 can have large surface areas where the heat dissipation fins 35, 36, 37, 38 contact air, and can cause much airflows to flow through the surfaces of the heat dissipation fins 35, 36, 37, 38 when those plates are stacked, thereby improving the heat dissipation effect.

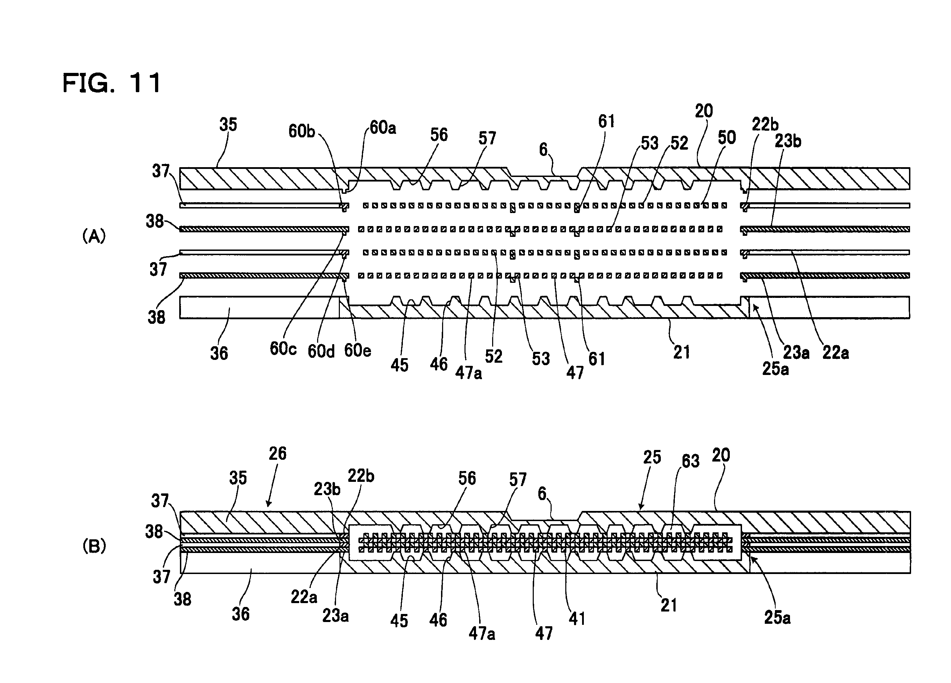

Next, an explanation will be given of a method for manufacturing the heat pipe 5. FIGS. 11(A) and 11(B), FIG. 12(A) to 12(C), and FIGS. 13(A) and 13(B) show an example of a manufacturing method of the heat pipe 5, and as shown in FIG. 11(A), the first pattern intermediate plate 22a, the second pattern intermediate plate 23a, the first pattern intermediate plate 22b, the second pattern intermediate plate 23b, and the upper plate 20 are stacked over the lower plate 21 in this order.

The upper plate 20 has a joining projection 60a which protrudes from the lower inside surface of the main body 30 and is formed in a frame-like shape along the peripheral portion. This enables the upper plate 20 to be directly joined to the first pattern intermediate plate 22b through the joining projection 60a. The upper outside surface of the upper plate 20 has the concave portion 6 and an area other than the concave portion undergone, for example, bright nickel plating beforehand, and thus a light reflective film is formed.

The first pattern intermediate plate 22b has a joining projection 60b which protrudes from the lower surface and is formed in a frame-like shape along the peripheral portion, and the second pattern intermediate plate 23b, the first pattern intermediate plate 22a and the second pattern intermediate plate 23a have joining projections 60c, 60d, and 60e, respectively, which protrude from the respective lower surfaces and are formed in a frame-like shape along the respective peripheral portions. In the embodiment, the joining projections 60a to 60d have a height of, for example, 35 µm or so, and a width of, for example, 50 µm or so.

Next, the first pattern intermediate plate 22a, the second pattern intermediate plate 23a, the first pattern intermediate plate 22b, the second pattern intermediate plate 23b, and the upper plate 20 are superimposed and stacked together at the most appropriate positions, the upper plate 20, the lower plate 21, the first pattern intermediate plates 22a, 22b, and the second pattern intermediate plates 23a, 23b are heated in this state at a temperature lower than a melting point, pressurized (i.e., subjected to heat press (the temperature is, for example, 300 °C, and the pressure is, for example, 100 kg/cm²)), and then directly joined together through the joining projections 60a to 60d.

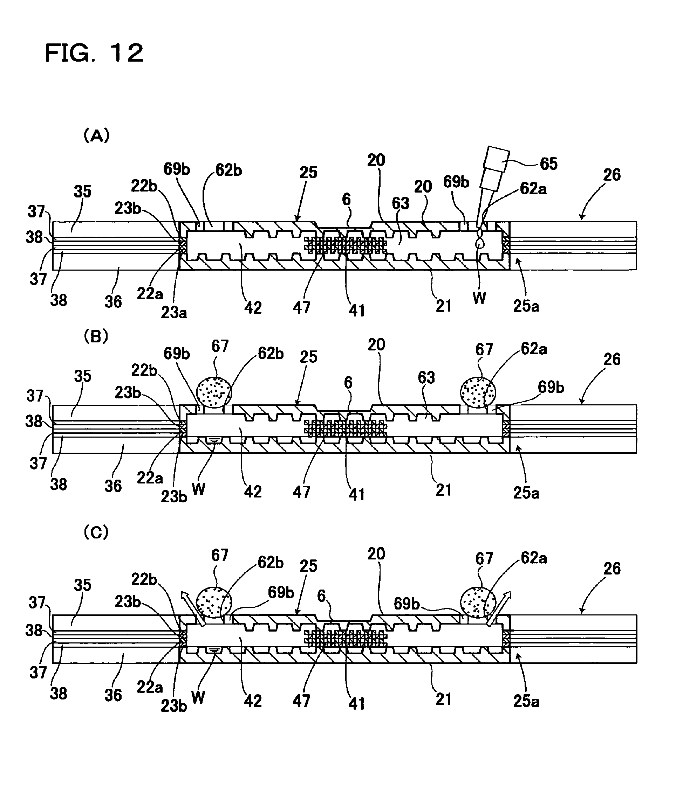

As shown in FIG. 11(B), by directly joining the peripheral portions through the joining projections 60a to 60d in this manner, the upper plate 20, the lower plate 21, the first pattern intermediate plates 22a, 22b, and the second pattern intermediate plates 23a, 23b are integrated together, and as shown in FIG. 12(A), an interior space 63 of the cooling unit main body 25 is communicated with the exterior thereof only through a refrigerant charging hole 62a and an air outlet port 62b which are formed in the main body 30 of the upper plate 20.

Each of the upper plate 20, the first pattern intermediate plates 22a, 22b, the second pattern intermediate plate 23a, 23b and the lower plate 21 has a projection 61 formed at a rectangular contour position facing the concave portion 6, and those projections 61 are directly joined for integration at the rectangular contour positions facing the concave portion 6, in addition to the integration of the peripheral portions, thus forming a support structure at a predetermined location of the concave portion opposite region 47. Providing the support structure at the concave portion opposite region 47 improves the mechanical strength of the cooling unit main body 25, and it is possible to prevent the destruction of the cooling unit main body 25 itself by phenomenon (hereinafter, Popcorn phenomenon) such that the refrigerant W is undergone thermal expansion due to heat from the LED chip 2 and the approximate center of the cooling unit main body expands outwardly.

By superimposing the respective vapor-diffusion-flow-path formation holes 48 of the first pattern intermediate plates 22a, 22b, and the second pattern intermediate plates 23a, 23b, the four vapor diffusion flow paths 42 which extend radially toward the four corners are formed in the interior space 63 of the cooling unit main body 25 (FIG. 2(B)). At the same time, by superimposing the capillary formation areas 50 of the first pattern intermediate plates 22a, 22b and the second pattern intermediate plates 23a, 23b, the plurality of minute capillary flow paths 41 are formed between the vapor diffusion flow paths 42 and in the concave portion opposite region in the interior space 63 of the cooling unit main body 25 (FIG. 2(A)).

Thereafter, as shown in FIG. 12(A) which shows the manufacturing method of the heat pipe 5 step by step, a predetermined amount of refrigerant W (e.g., water) is filled in the interior space 63 of the cooling unit main body 25 under an atmospheric pressure through the refrigerant charging hole 62a, using a refrigerant dispenser 65. At this time, the air outlet port 62b serves as an outlet port for air in filling the refrigerant, resulting in smooth filling of the refrigerant W in the interior space 63. In a case where the refrigerant is water, it is preferable that the filling amount thereof should be equal to the entire volumes of the through holes 52, 53.

Subsequently, predetermined number of sealing members 67 each formed in, for example, a spherical shape are prepared, and as shown in FIG. 12 (B) showing the manufacturing method of the heat pipe 5 step by step, the sealing members 67 are disposed on the refrigerant charging hole 62a and the air outlet port 62b.

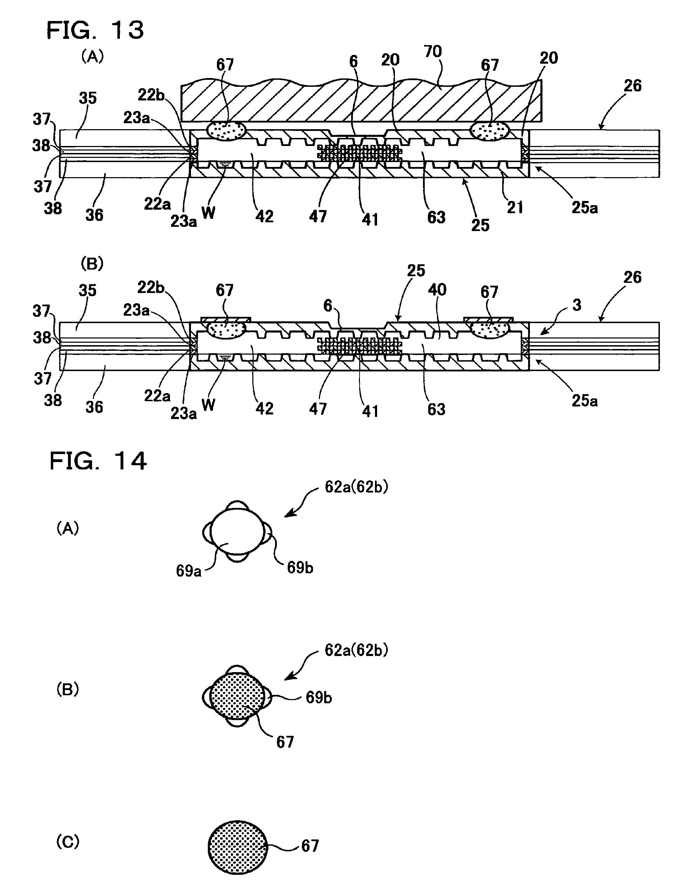

The refrigerant charging hole 62a and the air outlet port 62b are formed in the same shape, and as shown in FIG. 14(A) which shows the planar structure of the refrigerant charging hole 62a, it comprises a cylindrical opening 69a whose central part is most widely opened and degassing grooves 69b provided on the inside peripheral surface of the cylindrical opening 69a. In the embodiment, the degassing groove 69b is formed in a semi-cylindrical shape having a smaller diameter than that of the opening 69a, and arranged in four positions at equal intervals on the inner peripheral of the opening 69a.

Under that condition, vacuum deaeration (e.g., at 0.5KPa) is performed for about e.g., 10 minutes by pressure reduction through the degassing grooves 69b under a low temperature condition (from 0 °C to normal temperature (for example, about 25 °C)), and then under that low temperature state, the sealing member 67 is pressed (e.g., at 10-80 kg/ cm²) from above by a press 70 for several minutes so that it is subjected to low temperature pressure deformation. Thus, the refrigerant charging hole 62a and the air outlet port 62b are temporarily sealed by carrying out such low-temperature vacuum pressurization treatment. At that time, the refrigerant charging hole 62a and the air outlet port 62b are closed by the sealing member 67.

In the meantime, a temperature at which vacuum deaeration is to be performed is preferably as low as about 20 °C, and a pressure at which the sealing member 67 is to be subjected to low-temperature pressurization deformation is preferably about 60 kg/ cm².

As shown in FIG. 12 (C), the degassing grooves 69b enable the interior space 63 of the cooling unit main body 25 to be kept in fluid communication with the exterior even when the sealing member 67 is placed on the refrigerant charging hole 62a and the air outlet port 62b, thereby enabling the degassing of the interior space 63 of the cooling unit main body 25. Note that arrows shown in FIG. 12 (C) indicate degassing directions.

Those degassing grooves 69b serve to keep the interior space 63 of the cooling unit main body 25 communicated with the exterior not only when the sealing member 67 is placed on the refrigerant charging hole 62a but also when the sealing of the refrigerant charging hole 62a has proceeded to some extent so that they can be sealed by the sealing members 67 by the pressurization and heating after the low temperature vacuum heating treatment.

Next, after the low-temperature vacuum heating treatment, as shown in FIG. 13(A), the sealing members 67 are further pressed from above (at 30-150 kg/ cm²) by the press 70 for about 10 minutes, for example, under a high temperature condition (from normal temperature (e.g., about 25 °C) to 180 °C), with a degree of vacuum being set to 0.5KPa, for example. As a result, the sealing members 67 are turned into plastic flow, and subjected to high-temperature pressurization deformation so that the refrigerant charging hole 62a and the air outlet port 62b are more firmly closed by the sealing members 67.

A temperature at which the further pressing is to be performed by the press 70 is preferably a high temperature of 120 °C or so, and a pressure at which the sealing member 67 is to be subjected to high-temperature pressurization deformation is preferably about 100 kg/ cm².

That is, the sealing members 67 are tuned into plastic flow primarily by the pressurization, and secondarily by the heating, thus enabling the refrigerant charging hole 62a and the air outlet port 62b including the degassing grooves 69b to be sealed. After having sealed the refrigerant charging hole 62a and the air outlet port 62b by the sealing members 67, the heating and the vacuuming are stopped, and the pressurization by the press 70 is released, thus terminating these pressing, heating and vacuuming processes, and as a result, as shown in FIG. 13 (B), the originally spherical sealing members 67 are turned into the shape of the refrigerant charging hole 62a and the air outlet port 62b by plastic flow so that they may substantially serve as sealing plugs, sealing up the interior space 63 of the cooling unit main body 25 to thereby make up a sealed space 40.

According to the heat pipe 5, the boiling point of the refrigerant W drops because the sealed space 40 is brought under reduced pressure (e.g., about 0.5 KPa if the refrigerant W is water), and thus the refrigerant W turns into vapor more easily at a temperature of 50 °C or less (e.g., about 30 to 35 °C) slightly higher than a normal temperature.

Accordingly, according to the heat pipe 5, the refrigerant W is allowed to evaporate with a slight amount of heat from the LED chip 2, and then the vapor is allowed to diffuse through the vapor diffusion flow paths 42 toward the peripheral portion side, where the vapor is condensed and the refrigerant W thus liquefied is then allowed to pass through the capillary flow paths 41 due to capillary phenomenon, and return to the vicinity of the concave portion 6. Such a circulating phenomenon caused by the refrigerant W can be repeated easily and successively.

Moreover, according to the heat pipe 5, the refrigerant W can evaporate at a temperature slightly higher than a normal temperature so that the circulating phenomenon caused by the refrigerant W can be repeated successively, achieving heat homogenization, thus enabling the effective cooling of the LED chip 2.

Next, the heat pipe 5 manufactured in this manner is subjected to bonding of an insulating layer 11 through a bonding sheet on the main body 30 of the upper plate 20 where the light reflective film is formed. The bonding sheet and the insulating layer 11 have openings at portions corresponding to the concave portion 6, so that a bonding layer 10 and the insulating layer 11 are formed on areas other than the area of the concave portion 6. Subsequently, the wiring circuit board 12 having a copper wiring pattern and the masked electrode 13 is provided on the insulating layer 11, and bright nickel plating is performed on the wiring circuit board 12, thereby forming a light reflective film.

Thereafter, the LED chip 2 is bonded to the bottom surface of the concave portion 6 via the die bond 7, the mask on the electrode 13 is removed, and the LED chip 2 is electrically connected to the electrode 13 through the wirings 14. The LED chip 2, the electrode 13 and the wirings 14 are sealed by the transparent resin 15, thereby completing fabrication of the light emitting device 1.

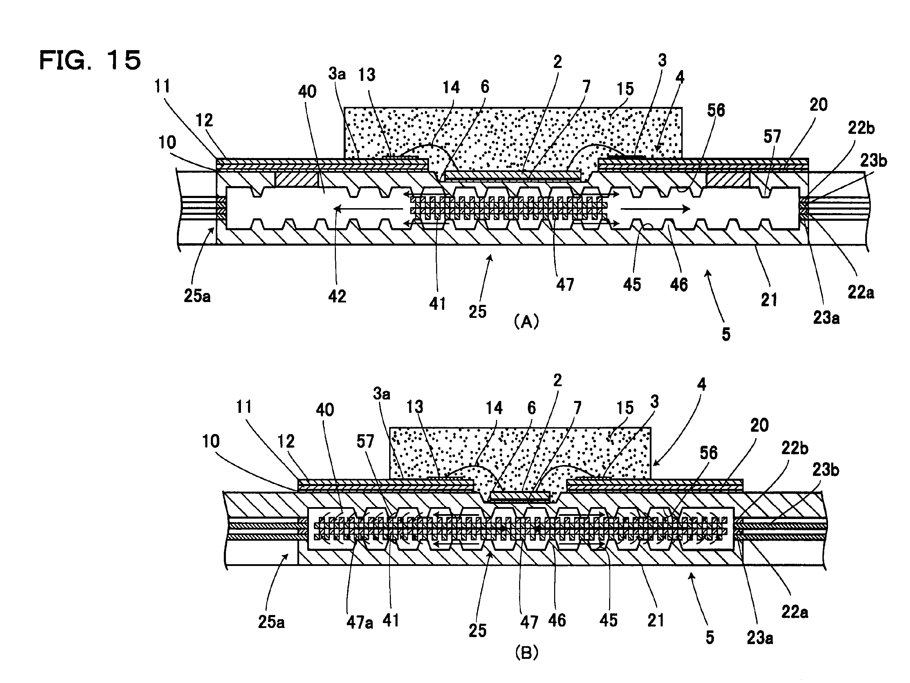

Unlike the conventional heat pipes, the heat pipe 5 employs the foregoing structure such that the vapor diffusion flow paths 42 which extend to the peripheral portion and the capillary flow paths 41 formed between the vapor diffusion flow paths 41 and at the concave portion opposite region are provided in the sealed space 40. Because the refrigerant W is always present in each capillary flow path 41 in the concave portion opposite region 47 due to capillary phenomenon, as shown in FIG. 15(A) showing the cross-sectional structure of a portion where the vapor diffusion flow paths 42 and the capillary flow paths 41 are formed along a line B-B' in FIG. 1, the refrigerant W in each capillary flow path 41 rapidly and surely absorbs heat from the projecting poles 57 and starts evaporation. The refrigerant W passes through the upper-plate-inside-surface groove portion 56 and the lower-plate-inside-surface groove portion 45, diffuses to the vapor diffusion flow paths 42, passes through the vapor diffusion flow paths 42, and then diffuses to the peripheral portion.

According to the heat pipe 5, as shown in FIG. 15(B) showing the cross-sectional structure of a portion which is filled up with the capillary flow paths 41 along a line A-A' in FIG. 1, the refrigerant W, which is undergone heat dissipation condensation and liquefied at the upper-plate-inside-surface groove portion 56, the lower-plate-inside-surface groove portion 45, and the vapor diffusion flow paths 42, enters into the capillary flow paths 41 from the upper-plate-inside-surface groove portion 56, and the lower-plate-inside-surface groove portion 45, is pulled by a negative pressure originating from the vaporization of the refrigerant W in the concave portion opposite region 47, passes through the capillary flow paths 41, and returns to the concave portion opposite region 47.

Meanwhile, to surely prevent Popcorn phenomenon, it is necessary to thicken the thickness of, for example, the upper plate, but if the thickness of the upper plate is simply thickened, conduction of heat from the cooling target device to the refrigerant in the cooling unit main body becomes difficult by what corresponds to the thickened thickness of the upper plate, so that the thermal conductivity to the refrigerant becomes inferior.

However, according to the heat pipe 5 of the invention, only a portion where the LED chip 2 is mounted serves as the concave portion 6, the thickness of the concave portion 6 is thinned and the upper plate 20 other than the area of the concave portion 6 is thickened to improve the mechanical strength thereof, so that heat from the LED chip 2 is easily conducted to the refrigerant in the cooling unit main body 25 by what corresponds to the thinning of the concave portion 6. Accordingly, even if the upper plate 20 is thickened to surely prevent Popcorn phenomenon, the thermal conductivity to the refrigerant in the cooling unit main body 25 can be surely ensured.

That is, according to the heat pipe 5, when the LED chip 2 starts light emission, most heats generated because of the light emission of the LED chip 2 rapidly transfer from the bottom portion 6b of the concave portion 6 to the projecting poles 57 provided at the upper-plate-inside-surface groove portion 56 by what corresponds to the thinning of the thickness of the concave portion 6. At this time, according to the heat pipe 5, because the LED chip 2 mounted in the concave portion 6 is surrounded by the peripheral walls 6b of the concave portion 6, heat can be also transfer to the projecting poles 57 from the peripheral walls 6b. In this manner, heat from the LED chip 2 rapidly transfers to the capillary formation regions 50 in the concave portion opposite region 47 from the bottom surface 6b and the peripheral walls 6b of the concave portion 6 through the projecting poles 57.

Accordingly, successive circulating phenomenon caused by the refrigerant W is surely repeated by heat from the LED chip 2 in the heat pipe 5 as shown in FIGS. 15(A) and 15(B), and large amount of heat from the LED chip 2 can be surely drawn by latent heat at a time when the refrigerant W vaporizes.

Because the heat pipe 5 employs a different structure from that of the conventional heat pipes such that the cooling unit main body 25 has the thin concave portion 6 and the LED chip 2 provided therein, heat from the LED chip 2 easily transfers to the refrigerant, a large amount of heat from the LED chip 2 is surely drawn by the cooling unit main body 25, thereby maintaining the light emitting state of the LED chip 2 stable without causing unstable light emission due to heat generation.

In the case of the embodiment, in the concave portion opposite region 47, the projections 61 are provided at the respective contour positions facing the concave portion 6, directly joined and form an integrated support structure, thereby preventing destruction of the concave portion 6 due to Popcorn phenomenon even if the concave portion 6 is thinned.

Because the heat pipe 5 causes the refrigerant W to circulate utilizing capillary phenomenon caused by the capillary flow paths 41 formed in the cooling unit main body 25 and diffusion of a vapor, it is not necessary to additionally provide an exclusive device for circulating the refrigerant, like a pump, so that the structure becomes simple, the device is miniaturized as a whole, and the LED chip 2 can be further effectively cooled in comparison with the conventional technologies.

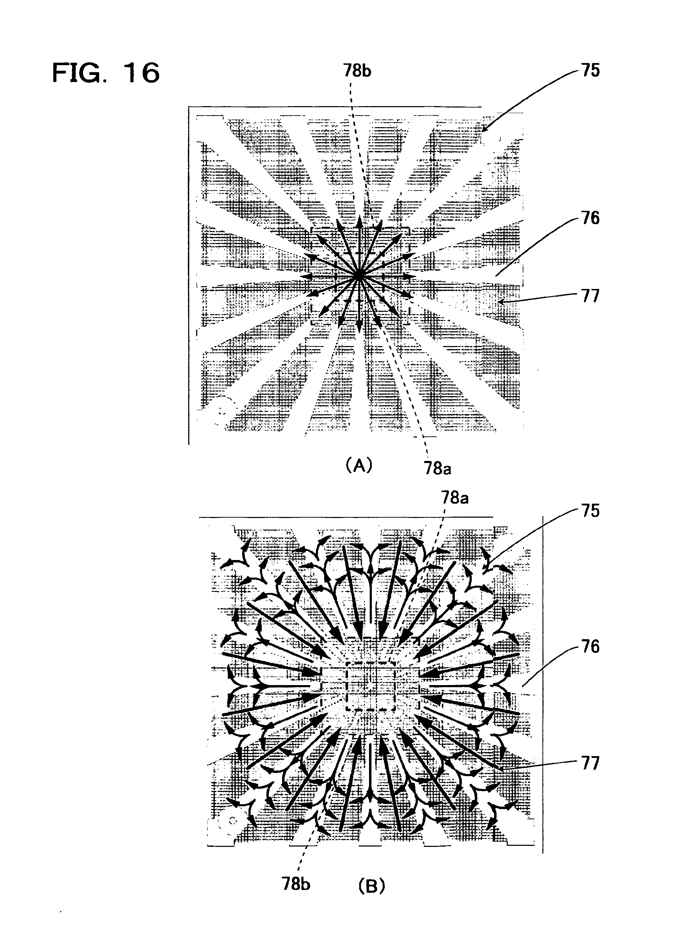

FIGS. 16(A) and 16(B) show a modified embodiment of the foregoing embodiment, and an upper plate 75 is structured in such a manner as to have a plurality of vapor diffusion flow paths 76 provided at not only portions on the diagonal lines but also at other portions. In the foregoing embodiment, the explanation has been given of the case where the capillary flow paths 41 are formed at the concave portion opposite region 47 in the mounting section 3a, but according to the modified embodiment in FIGS. 16(A) and 16(B), a capillary flow paths 77 may be formed at an entire mounting section opposite region 78b which faces the mounting section 3a (FIG. 1) in addition to a concave portion opposite region 78a, and a brief explanation will be given of the way how the refrigerant circulates with reference to FIGS. 16(A) and 16(B).

In this case, as shown in FIG. 16(A), the upper plate 75 causes the refrigerant W to radially diffuse along the vapor diffusion flow paths 76 with that region where the LED chip 2 is mounted taken as the center, and to reach the peripheral portion. At this time, as shown in FIG. 16(B), the refrigerant W is undergone heat dissipation condensation and liquefied through a process of passing through the vapor diffusion flow paths 76, enters into the capillary flow paths 77 through spaces, passes through the capillary flow paths 77 of the capillary formation regions disposed radially, and returns to the mounting section opposite region 78b, thus cooling the LED chip 2 uniformly from the peripheral portion.

Back to the foregoing embodiment now, according to the heat pipe 5, the first pattern intermediate plates 22a, 22b, and the second pattern intermediate plates 23a, 23b are stacked together successively and alternately to displace the respective through holes 52, 53, and the capillary flow paths 41 are formed in a direction inclined from the vertical direction, and in a direction perpendicular to the vertical direction, so that the refrigerant W can efficiently flow in the vertical and horizontal directions, and inclined directions in the cooling unit main body 25, thereby enhancing the cooling effect of the refrigerant W further.

Further, because the light emitting unit 4 mounted in the concave portion 6 is formed integrally, the heat pipe 5 employs a structure such that the LED chip 2 adheres tightly to the concave portion 6, and heat from the LED chip 2 is rapidly conducted to the cooling unit main body 25, thereby enhancing the cooling effect.

In addition, because the heat pipe 5 has the capillary flow paths 41 formed in the concave portion opposite region 47 facing the concave portion 6 where the LED chip 2 is mounted in the sealed space 40, the refrigerant can be surely collected in the concave portion opposite region 47 before the LED chip 2 generates heat by capillary phenomenon caused by the capillary flow paths 41.

Therefore, according to the heat pipe 5, even if the cooling unit main body 25 is inclined in the vertical direction and various directions in which the upper and lower surfaces are inverted to emit light from the LED chip 2 in various directions for example, the refrigerant is collected in the concave portion opposite region 47 against the gravity by capillary phenomenon caused by the capillary flow paths 41, thereby allowing the refrigerant in the concave portion opposite region 47 to evaporate by heat from the LED chip 2. According to the heat pipe 5, even if the cooling unit main body 25 is inclined in various directions, the refrigerant W can be led to the concave portion opposite region 47 by capillary phenomenon caused by the capillary flow paths 41, so that it is possible to emit light in a desired direction while heat generated from the LED chip 2 is drawn by the refrigerant W.

The heat pipe 5 has the concave portion 6 which is formed in the upper outside surface of the upper plate 20 constituting the cooling unit main body 25 and is so formed as to be thinner than the other regions of the upper plate 20, and the LED chip 2 is mounted in the concave portion 6. Therefore, the heat pipe 5 can cause light L from the LED chip 2 to hit the peripheral walls 6b and the bottom face 6b of the concave portion 6, so that the light is subjected to spherical reflection, and thus efficiently emitting light in a desired direction (FIG. 3).

Because the heat pipe 5 has the plurality of heat dissipation fins 35, 36, 37, and 38 provided at the respective outer peripheral portions of the upper plate 20, the lower plate 21, the first pattern intermediate plates 22a, 22b, and the second pattern intermediate plates 23a, 23b, heat diffused to the peripheral portion of the cooling unit main body 25 by the refrigerant W is conducted to the heat dissipation fins 35, 36, 37, and 38, and conducted to outside air having a large heat capacity, and dissipated not only from the main body 30 of the upper plate 20 and the main body 31 of the lower plate 21, but also from the heat dissipation fins 35, 36, 37, 38, thereby further enhancing the heat dissipation effect.

Moreover, because the heat pipe 5 has the heat dissipation fins 35, 36, 37, and 38 formed at the respective outer peripheral portions 25a of the upper plate 20, the lower plate 21, the first pattern intermediate plates 22a, 22b, and the second pattern intermediate plates 23a, 23b and displaced with one another beforehand, it is easy to form the cooling unit main body 25 which has the adjoining heat dissipation fins 35, 36, 37, and 38 displaced with one another plate by plate by merely stacking and directly joining the upper plate 20, the lower plate 21, the first pattern intermediate plates 22a, 22b, and the second pattern intermediate plates 23a, 23b.

Accordingly, the heat pipe 5 can reduce a work process in comparison with a case where heat dissipation fins separate from the cooling unit main body are attached to the cooling unit main body through bonding layers, and has no thermal resistance inherent to a bonding layer, so that no large temperature difference between the cooling unit main body 25 and the heat dissipation fins 35, 36, 37, and 38 is caused, and the heat dissipation fins 35, 36, 37, and 38 can efficiently dissipate heat.

Further, according to the heat pipe 5, by displacing the positions of the heat dissipation fins 35, 36, 37, 38 of any two adjoining plates, the plurality of heat dissipation fins 35, 36, 37, and 38 do not contact one another, the surface area which contacts outside air having a large heat capacitance is taken widely as much as possible, heat is surly conducted to the outside air, thereby enhancing the heat dissipation effect.

Although the explanation has been given of the case where the capillary flow paths 41 are formed in the entire concave portion opposite region 47 in the first embodiment, the present invention is not limited to this case, and the capillary flow paths 41 may be formed in a part of the concave portion opposite region 47.

### (Second Embodiment)

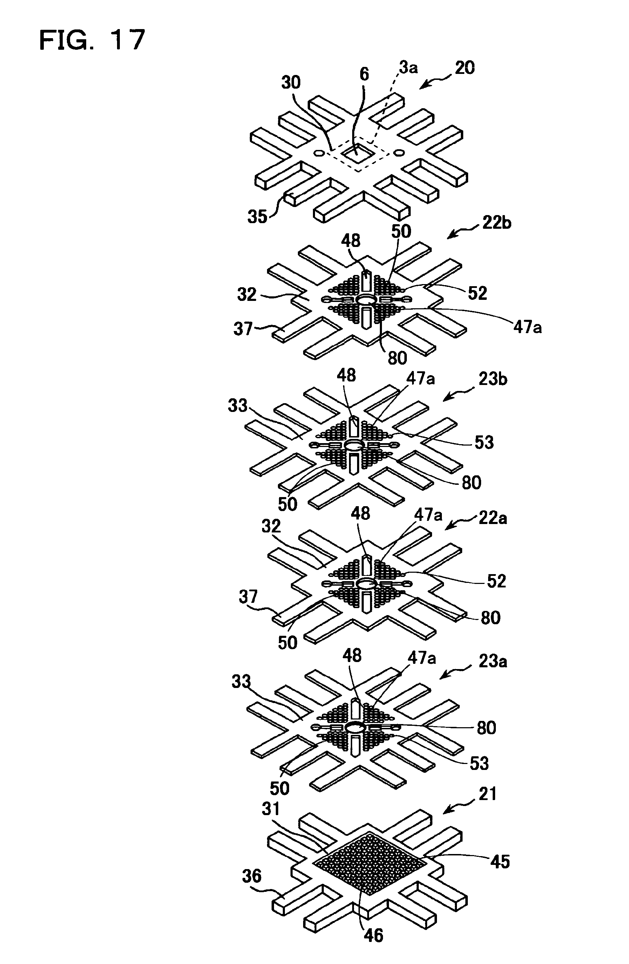

As shown in FIG. 17 where the same structural portions as those in FIG. 4 are denoted by the same reference numerals, a heat pipe of the second embodiment has different structure from the first embodiment such that a concave portion opposite through hole 80 is formed in the concave portion opposite region in each main body 32, 33 of the first pattern intermediate plates 22a, 22b and the second pattern intermediate plates 23a, 23b. Also in this case, large amount of heat from the LED chip 2 is conducted to the refrigerant through the concave portion 6, and the successive circulation of the refrigerant is surely repeated, so that large amount of heat from the LED chip 2 is surely drawn by latent heat at a time when the refrigerant vaporizes, thereby cooling the LED chip 2 more efficiently by heat dissipation in comparison with the conventional technologies.

The concave portion opposite through holes 80 are merely superimposed on one another to form a hollow region in the second embodiment, but the invention is not limited to this case, and a fiber member may be filled in the hollow region formed by superimposing the concave portion opposite through holes 80 one another to form a fiber region.

In this case, the fiber region formed by filling the fiber member in the hollow region can cause capillary phenomenon by thickening the fiber member at a high density.

Therefore, even if the cooling unit main body is inclined at various angles, the heat pipe can cause the refrigerant to be collected in the fiber region by capillary phenomenon before the cooling target device generates heat, so that when the cooling target device starts generating heat, heat from the cooling target device is rapidly conducted to the refrigerant in the fiber region, thereby starting cooling of the cooling target device.

Moreover, even if the cooling unit main body is inclined at various angles, the heat pipe can surely introduce the refrigerant to the vicinity of the cooling target device against the gravity by capillary phenomenon caused by the fiber region, so that heat generated from the cooling target device can be cooled by the refrigerant.

### (Third Embodiment)

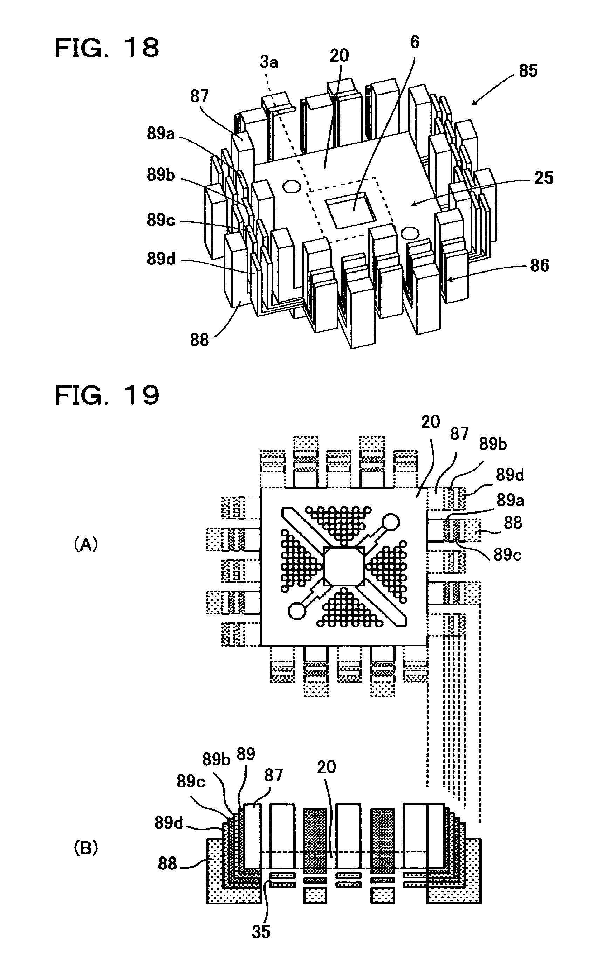

As shown in FIG. 18 where the same structural portions as those in FIG. 5 are denoted by the same reference numerals, a reference number 85 denotes a heat pipe of the third embodiment, and the heat pipe 85 has a different structure from that of the first embodiment such that a heat dissipation fin array 86 is bent vertically toward the upper plate 20 of the cooling unit main body 25.

FIG. 19(A) is a plan view showing the heat pipe 85 formed by bending the heat dissipation fin array 86 vertically with respect to the upper plate 20, and FIG. 19(B) is a side view thereof. Heat dissipation fins 87 of the upper plate 20, heat dissipation fins 88 of the lower plate 21, heat dissipation fins 89a of the first pattern intermediate plate 22b, heat dissipation fins 89b of the second pattern intermediate plate 23b, heat dissipation fins 89c of the first pattern intermediate plate 22a, and heat dissipation fins 89d of the second pattern intermediate plate 23a are all bent vertically toward the upper plate 20 of the cooling unit main body 25.

In the case of this embodiment, the heat pipe 85 has the cooling unit main body 25 formed to the size of 5 mm by 5 mm, the thicknesses of the upper and lower plates 20, 21 are formed to 0.5 mm, respectively, and the thicknesses of the first pattern intermediate plates 22a, 22b and the second pattern intermediate plates 23a, 23b are formed to 0.1 mm.

The heat dissipation fins 87 of the upper plate 20 are vertically bent in such a way that the inner peripheral surfaces thereof run along the outer peripheral surface of the outer peripheral portion 25a of the cooling unit main body 25. Next, the heat dissipation fins 89a of the first pattern intermediate plate 22b adjacent to and below the upper plate 20 are bent in such a way that inner peripheral end portions thereof form a clearance of 0.5 mm, which is equal to the thickness of the upper plate 20, with the outer peripheral end of the cooling unit main body 25.

Subsequently, the heat dissipation fins 89b of the second pattern intermediate plate 23b are bent in such a way that the inner peripheral end portions thereof form a clearance of 0.1 mm with the outer peripheral end portions of the heat dissipation fins 87 of the upper plate 20. Next, the heat dissipation fins 89c of the first pattern intermediate plate 22a are bent in such a way that the inner peripheral portions thereof form a clearance of 0.1 mm with the outer peripheral end portions of the heat dissipation fins 89a of the first pattern intermediate plate 22b. Thereafter, the heat dissipation fins 89d of the second pattern intermediate plate 23a are bent in such a way that the inner peripheral end portions thereof form a clearance of 0.1 mm with the outer peripheral end portions of the heat dissipation fins 89b of the second pattern intermediate plate 23b.

Finally, the heat dissipation fins 88 of the lower plate 21 are bent in such a way that the inner peripheral end portions thereof form a clearance of 0.1 mm with the outer peripheral end portions of the heat dissipation fins 89c of the first pattern intermediate plate 22a. As a result, it is possible to provide a clearance of 0.1 mm between two superimposed heat dissipation fins. By shifting the respective bending positions of the heat dissipation fins 87 of the upper plate 20, the heat dissipation fins 88 of the lower plate 21, the heat dissipation fins 89a of the first pattern intermediate plate 22b, the heat dissipation fins 89b of the second pattern intermediate plate 23b, the heat dissipation fins 89c of the first pattern intermediate plate 22a, and the heat dissipation fins 89d of the second pattern intermediate plate 23a from distal ends to leading ends, it is possible to form a clearance of 0.1 mm between any two of the heat dissipation fins 87, 88, 89a to 89d.

According to the heat pipe 85 having the foregoing structure, when the upper plate 20, the lower plate 21, the first pattern intermediate plates 22a, 22b, and the second pattern intermediate plates 23a, 23b are stacked together, the adjoining two fins in the heat dissipation fins 87, 88, 89a to 89d do not overlap with each other and form a clearance G therebetween, and the surface area where the heat dissipation fins 87, 88, 89a to 89d contact air can be taken widely, so that more airflows can flow through the surfaces of the individual heat dissipation fins 87, 88, 89a to 89d when those plates are stacked, thereby enhancing the heat dissipation effect.

Because the heat pipe 85 has the heat dissipation fins 87, 88, 89a to 89d bent vertically with respect to the surface of the cooling unit main body 25, it is possible to reduce the area of the whole heat pipe 85 in the width direction while enduring the cooling performance thereof through the heat dissipation fins 87, 88, 89a to 89d, so that it is possible to cope with a case where a space is limited.

In the foregoing embodiment, the explanation has been given of the case where the individual heat dissipation fins 87, 88, 89a to 89d are vertically bent with respect to the surface of the cooling unit main body 25, but the invention is not limited to this case, and the heat dissipation fins 87, 88, 89a to 89d may be bent at an arbitrary angle within a range from a horizontal plane of the surface of the cooling unit main body 25 to a vertical plane thereof. In this case, it is possible to ensure the maximum cooling performance at a desired size, in consideration of the limitation of a space in vertical and widthwise directions while maintaining the necessary cooling performance. Note that FIG. 18 shows the heat dissipation fins 87, 88, 89a to 89d bent upwardly toward the upper plate 20, but those fins may be bent downwardly toward the lower plate 21 in some cases.

### (Fourth Embodiment)

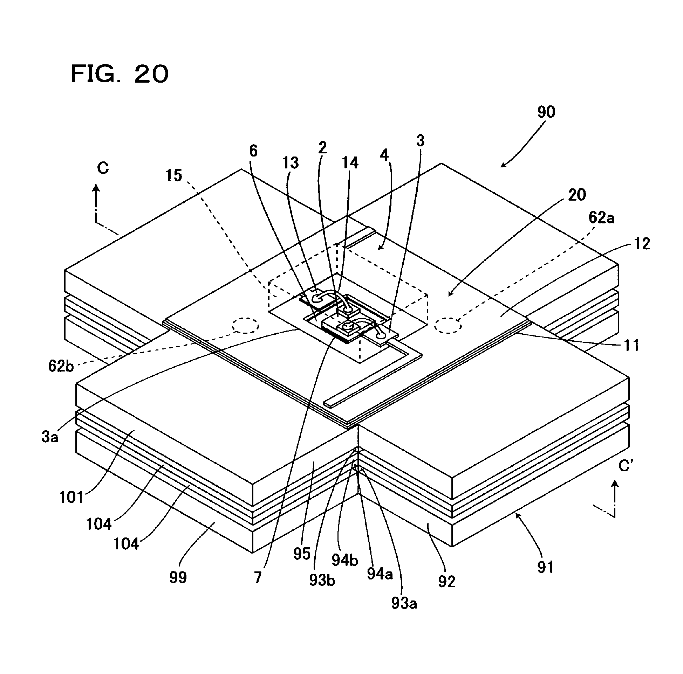

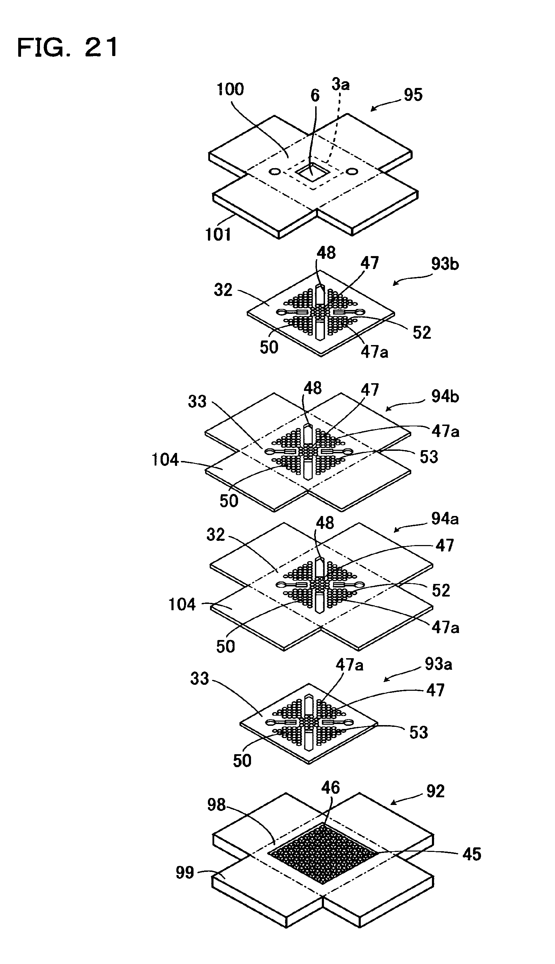

As shown in FIG. 20 where the same structural portions as those in FIG. 1 are denoted by the same reference numerals, reference number 90 denotes a light emitting device according to the fourth embodiment which has a heat pipe 91 structured differently from that of the first embodiment. In practice, as shown in FIG. 21 where the same structural portions as those in FIG. 4 are denoted by the same reference numerals, the heat pipe 91 is structured by stacking a fin-less intermediate plate 93a, two fin-provided intermediate plates 94a, 94b on a lower plate 92, stacking a fin-less intermediate plate 93b and an upper plate 95 thereon in this order, and integrating those plates together.

In the embodiment, the lower plate 92 comprises a tabular main body 98 formed in a square shape, and tabular and oblong heat dissipation fins 99 formed continuously and integrally with the four sides of the main body 98. Each heat dissipation fin 99 has a long side which has the same size as that of one side of the main body 98, and is provided across the one side entirely.

Likewise the lower plate 92, the upper plate 95 comprises a tabular main body 100 formed in a square shape, and tabular and oblong heat dissipation fins 101 formed continuously and integrally with the four sides of the main body 100. Each heat dissipation fin 101 has a long side which has the same size as that of one side of the main body 100, is formed across the one side entirely, and has a short side which has the same size as that of the short side of the heat dissipation fin 99 of the lower plate 92.

The fin-less intermediate plate 93a or 93b comprises a tabular main body 33 or 32 formed in a square shape like the main body 98 of the lower plate 92. Regarding the main bodies 32, 33, the structures of the through holes 52, 53 are the same as those of the first embodiment, so that redundant explanations thereof will be omitted here. On the other hand, the fin-provided intermediate plates 94a, 94b has tabular and oblong heat dissipation fins 104 which are formed in the same shape, and formed continuously and integrally with four sides of main bodies 32, 33 that are formed in a rectangular shape like the main body 98 of the lower plate 92. Each heat dissipation fin 104 has a long side which has the same size as that of one side of the main bodies 32, 33, is provided across the one side entirely, and has a short side which has the same size as those of the short side of the heat dissipation fin 99 of the lower plate 92 and the short side of the heat dissipation fin 101 of the upper plate 95.

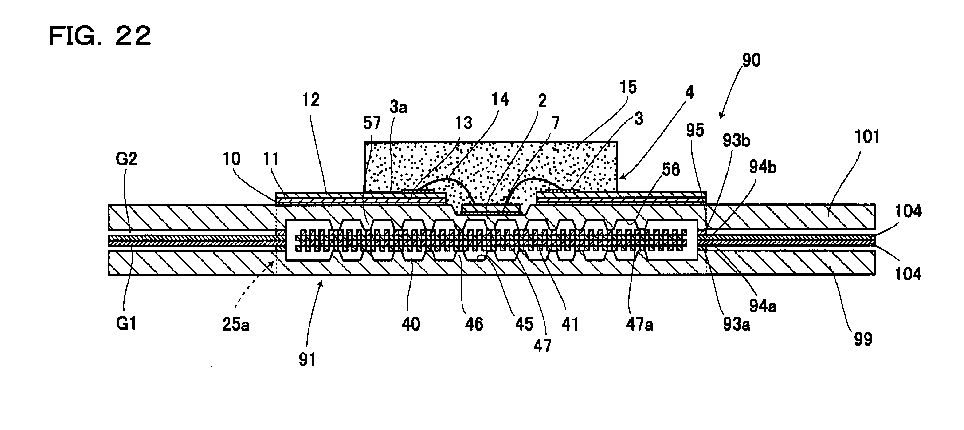

Accordingly, as shown in FIG. 22 which is a cross-sectional view along a line C-C' in FIG. 20 and where the same structural portions as those in FIG. 2 are denoted by the same reference numerals, the lower plate 92, the fin-less intermediate plate 93a, the two fin-provided intermediate plates 94a, 94b, the fin-less intermediate plate 93b and the upper plate 95 are stacked in sequence and integrated together by direct joining while positioning the respective main bodies 32, 33, 98, and 100 with respect to one another, thereby forming the heat pipe 91 having the respective heat dissipation fins 104 of the fin-provided intermediate plates 94a, 94b overlapped at a position between the lower plate 92 and the upper plate 95.

The heat pipe 91 has a clearance G1 formed between the heat dissipation fin 99 of the lower plate 92 and the heat dissipation fin 104 of the fin-provided intermediate plate 94a by what corresponds to the thickness of the fin-less intermediate plate 93a, and has a clearance G2 formed between the heat dissipation fin 99 of the upper plate 95 and the heat dissipation fin 104 of the fin-provided intermediate plate 94b by what corresponds to the thickness of the fin-less intermediate plate 93b.

According to the heat pipe 91 structured in the foregoing way, it is possible to form clearances between the heat dissipation fin 101 of the upper plate 95 and the heat dissipation fin 104 of the fin-provided intermediate plate 94a or 94b, and between the heat dissipation fin 99 of the lower plate 92 and the heat dissipation fin 104 of the fin-provided intermediate plate 94a, 94b by appropriately providing the fin-less intermediate plates 93a, 93b having no heat dissipation fin between the upper plate 95 and the lower plate 92, and between the fin-provided intermediate plates 94a, 94b when the heat dissipation fins 104 each formed in the same shape are formed continuously and integrally at the respective four sides of the upper plate 95, the lower plate 92, and the fin-provided intermediate plates 94a, 94b, and each of which is formed across one side entirely. Therefore, the surface area where the heat dissipation fins contact air can be taken widely, and more airflows can pass through the surface of each heat dissipation fin, resulting in the enhanced heat dissipation effect.

In this case, regarding the fin-provided intermediate plates 94a, 94b, one rectangular heat dissipation fin 104 is formed at each side, so that a complicated process for forming a plurality of band-like heat dissipation fins 104 at each side of the main bodies 32, 33 becomes unnecessary, thereby reducing a work process in comparison with the third embodiment.

### (Fifth Embodiment)

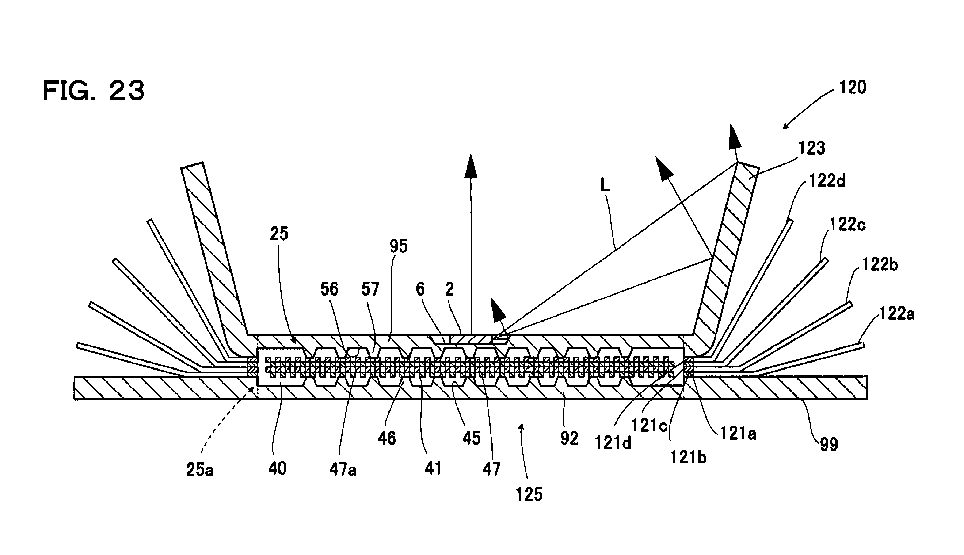

As shown in FIG. 23 where the same structural portions as those in FIG. 22 are denoted by the same reference numerals, a heat pipe 120 of the fifth embodiment has differences from the fourth embodiment such that only a plurality of fin-provided intermediate plates 121 a to 121 d are sandwiched between the lower plate 92 and the upper plate 95 and those plates are integrated together without providing the fin-less intermediate plates 93a, 93b therebetween, and heat dissipation fins 122a to 122 d of the fin-provided intermediate plates 121 a to 121 d and heat dissipation fins 123 of the upper plate 95 are bent at different angles.

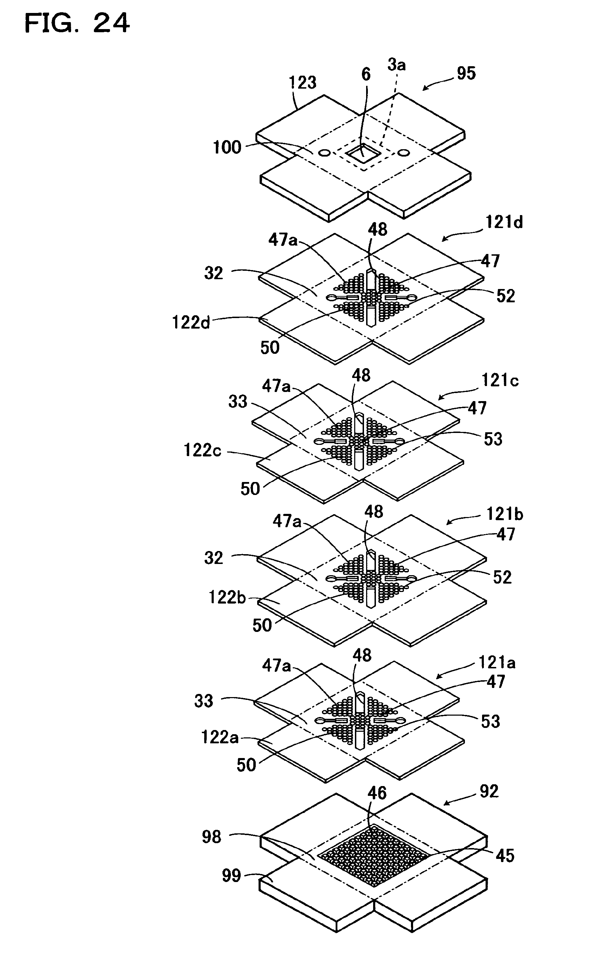

In practice, as shown in FIG. 24 where the same structural portions as those in FIG. 4 are denoted by the same reference numerals, the heat pipe 120 employs the structure such that the four fin-provided intermediate plates 121 a to 121 d and the upper plate 95 are stacked on the lower plate 92 successively and integrated together. In addition to such a structure, a light reflective material like nickel is formed on not only the upper surface of the main body 100, but also on the upper surfaces of the heat dissipation fins 123 by performing a film formation process, such as plating or metal deposition, so that the upper plate 95 has a light reflective film 125.

The four heat dissipation fins 123 provided at the upper plate 95 have portions which are formed continuously and integrally with the main body 100 and bent in the same direction with respect to the upper surface of the main body 100 at an angle less than or equal to an acute angle, thereby causing light from the LED chip 2 to reflect the heat dissipation fins in a desired direction. The bending angle of the heat dissipation fins is set to an appropriate angle in accordance with a direction in which light from the LED chip 2 is to be emitted.

The heat dissipation fins 122a to 122d provided at the fin-provided intermediate plates 121 a to 121 d, respectively, are bent at an arbitrary angle between the heat dissipation fins 123 of the upper plate 95 which are bent at an angle less than or equal to an acute angle, and the heat dissipation fins 99 of the lower plate 92 which are not bent and extend in the horizontal direction, so that each of the heat dissipation fins 122a to 122d does not contact another fin.

In this case, the fin-provided intermediate plates 121a to 121d have the respective heat dissipation fins 122a to 122d bent in such a manner as to come close to the main bodies 32, 33 plate by plate from the lower plate 92 to the upper plate 95, so that adjoining fins in the heat dissipation fins 122a to 122d do not contact each other.

According to the heat pipe 120 employing the foregoing structure, the heat dissipation fins, 123, 99, 122a to 122d which are formed at the upper plate 95, the lower plate 92, the fin-provided intermediate plates 121a to 121 d, respectively, do not overlap tightly but form clearances therebetween when those plates are stacked, so that the surface area where the heat dissipation fins 122a to 122d contact air can be taken widely, and more airflows can pass through the surfaces of the heat dissipation fins 122a to 122d when those plates are stacked, thereby enhancing the heat dissipation effect.

Because the heat pipe 120 has the heat dissipation fins 122a to 122d each bent vertically with respect to the surface of the cooling unit main body 25, the entire area of the heat pipe 120 can be reduced while ensuring the cooling performance through the heat dissipation fins 122a to 122d, and it is possible to cope with a case where a space is limited.

Further, because the upper plate 95 has the light reflective film 125 formed on the upper surface thereof, light from the LED chip 2 is illuminated to the upper surface of the heat dissipation fin 123, and can be subjected to spherical reflection, and thus emitting light in a desired direction more efficiently.

### (Sixth Embodiment)

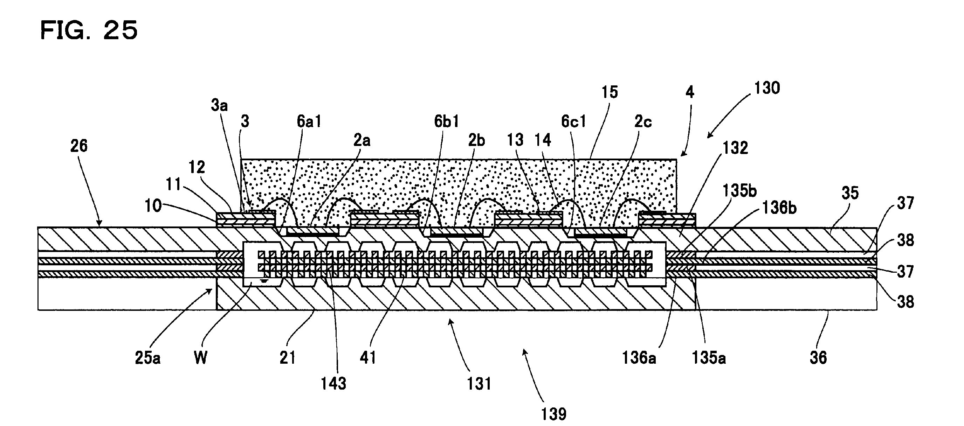

As shown in FIG. 25 where the same structural portions as those in FIG. 2(A) are denoted by the same reference numerals, a light emitting device 130 of the sixth embodiment has, for example, three concave portions 6a1, 6b1, and 6c1 provided in an upper plate 132 which constitutes a heat pipe 131, and a blue LED chip 2a, a red LED chip 2b, and a green LED chip 2c are mounted in the concave portion 6a1, 6b1, 6c1, respectively. The light emitting device 130 can emit a desired color of light while maintaining a necessary amount of light by controlling the individual light emissions of a LED array comprising the blue LED chip 2a, the red LED chip 2b, and the green LED chip 2c.

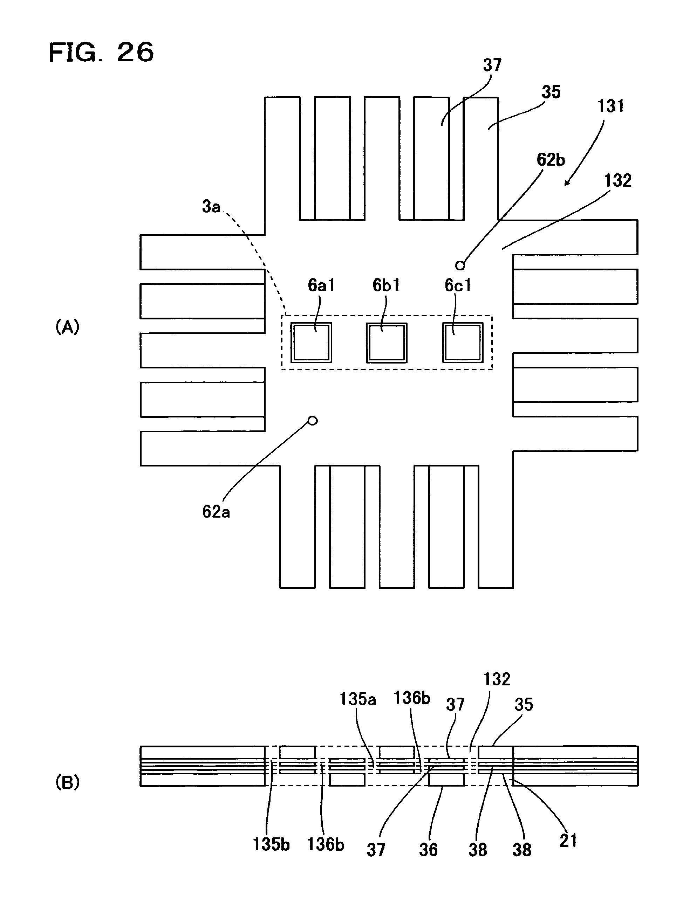

FIG. 26(A) is a front view showing the planar structure of the heat pipe 131 of the sixth embodiment, and FIG. 26(B) is a side view thereof. In practice, according to the sixth embodiment, the concave portions 6a1, 6b1, 6c1 which correspond to the contours of the blue LED chip 2a, the red LED chip 2b, and the green LED chip 2c, respectively, are provided in an upper surface 133 of the upper plate 132 formed in a square shape at even intervals in line. The number of concave portions 6a1, 6b1, 6c1, and the positions thereof may be increased in accordance with the number of the blue LED chip 2a, the red LED chip 2b, and the green LED chip 2c which become necessary according to the application thereof, and the concave portions 6a1, 6b1, and 6c1 may be formed in, for example, a circular or rectangular shape.

The light emitting device 130 has one heat pipe 131 where the LED array comprising, for example, the blue LED chip 2a, the red LED chip 2b, and the green LED chip 2c can be disposed in this manner. In the case of this embodiment, the structures of the heat dissipation fins 35, 37, 38, 36 of the upper plate 132, first pattern intermediate plates 135a, 135b, second pattern intermediate plates 136a, 136b and the lower plate 21 are the same as those of the first embodiment, so that the redundant explanations thereof will be omitted, and an explanation will be given while focusing on a cooling unit main body 139.

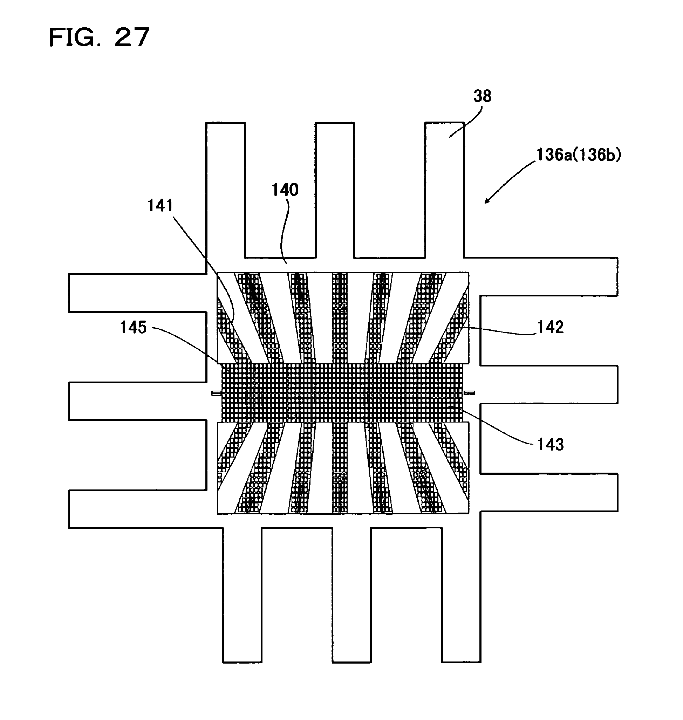

In practice, as shown in FIG. 27, the first pattern intermediate plate 135a, 135b has a plurality of through holes 145 formed in a region 143 corresponding to the positions of the plurality of concave portions 6a1, 6b1, and 6c1 of the upper plate 132 arranged in line (hereinafter, concave-portion-array corresponding region) in the first pattern (explained in the first embodiment). In this case, the concave-portion-array corresponding regions 143 locate at the center of main bodies 140 of the first pattern intermediate plates 135a, 135b linearly because the concave portions 6a1, 6b1, and 6c1 are linearly provided in line at the center of the upper plate 132.

A plurality of band-like vapor-diffusion-flow-path formation holes 141 which extend radially from the concave-portion-array corresponding region 143 toward the peripheral portion are formed in the main body 140 of the first pattern intermediate plate 135a, 135b, and a plurality of through holes 145 are formed between the adjoining vapor-diffusion-flow-path formation holes 141 in the first pattern. The second pattern intermediate plate 136a, 136b has the vapor-diffusion-flow-path formation holes 141 formed in the same positions as those of the first pattern intermediate plate 135a, 135b, and a plurality of through holes formed in the concave-portion-array corresponding region 143 and between the adjoining vapor-diffusion-flow-path formation holes 141 in the second pattern (explained in the first embodiment).

Accordingly, the heat pipe 131 has the cooling unit main body 139 formed by successively and alternately sandwiching the first pattern intermediate plates 135a, 135b, and the second pattern intermediate plates 136a, 136b between the lower plate 21 and the upper plate 132 and integrating those plates, and the vapor diffusion flow paths 42 and the capillary flow paths 41 can be formed in the cooling unit main body 139 by the first pattern intermediate plates 135a, 135b and the second pattern intermediate plates 136a, 136b.

According to the foregoing structure, the heat pipe 131 can effectively diffuse heat generated by light emission of the LED array comprising the blue LED chip 2a, the red LED chip 2b, and the green LED chip 2c toward the peripheral portion by the refrigerant W passing through the vapor diffusion flow paths 42 formed in the sealed space 40 of the heat pipe 131, a vapor of the refrigerant dissipates the heat and is condensed at the peripheral portion.

Because the capillary flow paths 41 are formed between the vapor diffusion flow paths 42 and in the concave portion array corresponding regions 143, the heat pipe 131 can surely return the refrigerant to the downward side of the blue LED chip 2a, the red LED chip 2b, and the green LED chip 2c through the capillary flow paths 41 by capillary phenomenon.

According to the heat pipe 131, such successive circulating phenomenon caused by the refrigerant W is surely repeated, heats from the blue LED chip 2a, the red LED chip 2b, and the green LED chip 2c are surely drawn by latent heat at a time when the refrigerant W vaporizes, the LED array is cooled more efficiently in comparison with the conventional technologies at the same time by heat dissipation, so that heat hardly remains in the individual concave portions 6a1, 6b1, and 6c1 even if the blue LED chip 2a, the red LED chip 2b, and the green LED chip 2c are provided in the concave portions 6a1, 6b1, and 6c1, respectively, thus preventing the LED array from becoming an unstable light emitting state due to heat generation.

The explanation has been given of the case where the light emitting unit 4 is provided on the heat pipe 5 in the foregoing embodiments, but the invention is not limited to this case, and the heat pipe 5 may not be provided with the light emitting unit 4, and a device to be cooled, such as an IC (Integrated Circuit), an LSI (Large Scale Integrated circuit) or a CPU may be provided in place of the light emitting unit 4.

### (2) Verification Test

Regarding a heat pipe of the invention having heat dissipation fins formed continuously and integrally with a cooling unit main body (hereinafter, first example), a copper-made heat spreader having heat dissipation fins separately attached to four sides of a copper plate through bonding layers (hereinafter, comparative example), and a heat pipe comprising a cooling unit main body having no heat dissipation fin (hereinafter, second example), a verification test for the thermal diffusion properties thereof were performed.

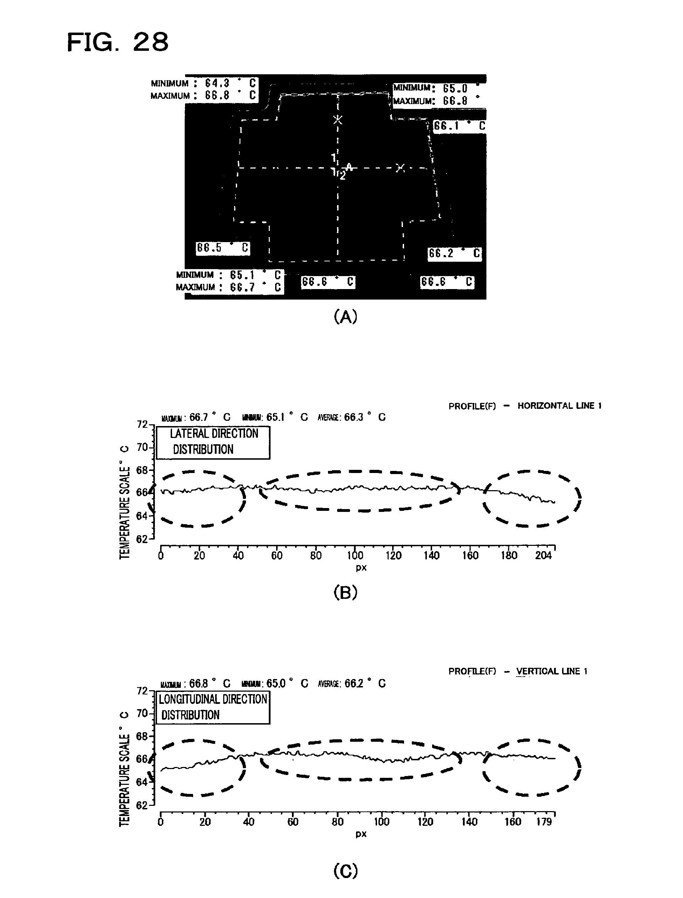

In the verification test, as shown in FIG. 28(A), a heat pipe comprising a cooling unit main body which had a size of 40 mm by 40 mm and had vapor diffusion flow paths and capillary flow paths thereinside, and heat dissipation fins each formed in a size of 10 mm by 40 mm, and formed continuously and integrally with the cooling unit main body was used as the first example.

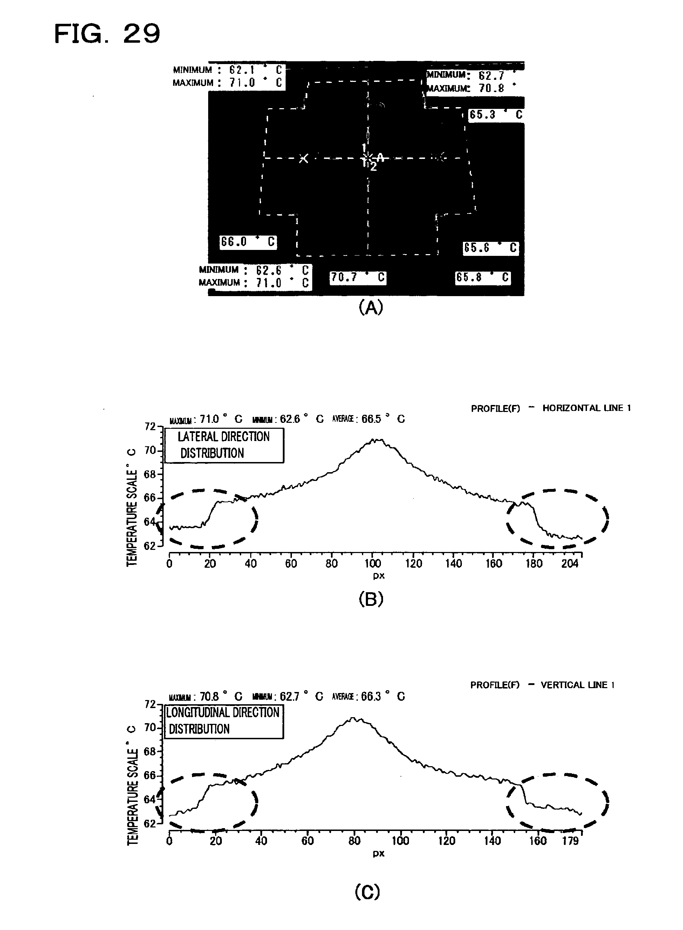

As shown in FIG. 29(A), a copper-made heat spreader comprising a copper plate which had a size of 40 mm by 40 mm, and a thickness of 2 mm, and heat dissipation fins each having a size of 10 mm by 40 mm, and separately attached to the side of the copper plate through a bonding layer was used as the comparative example.

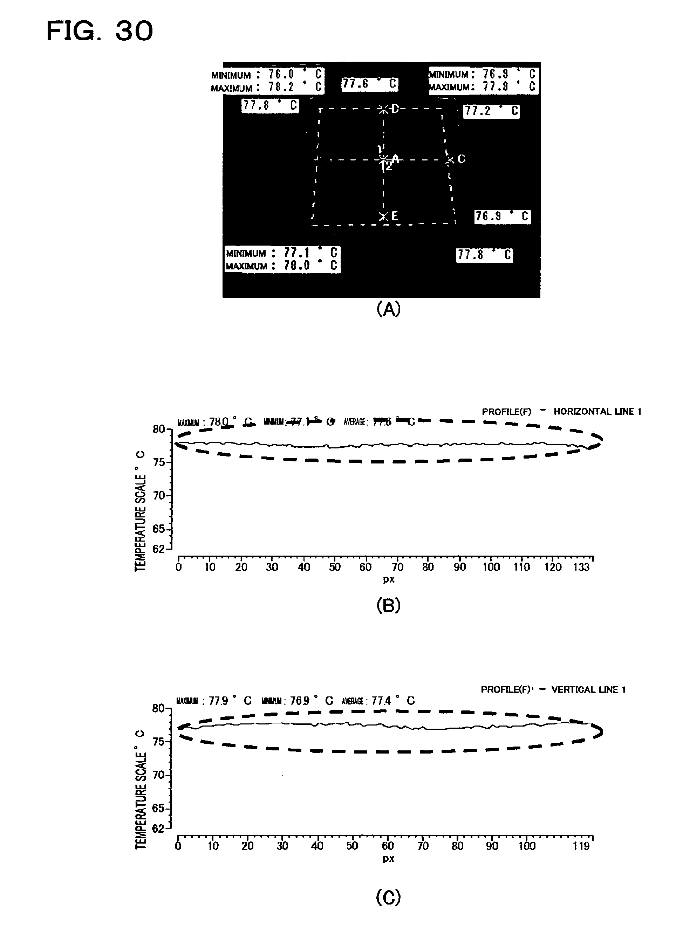

Further, as the second example, as shown in FIG. 30(A), a heat pipe having a size of 40 mm by 40 mm, formed in a rectangular shape, and having vapor diffusion flow paths and capillary flow paths was used.

Areas of 5 mm by 5 mm (not shown) at the centers of lower outside surfaces of first example, the comparative example, and the second example which served as the mounting sections were heated by a heater at 30 W under a laboratory environment of 21 °C, and the individual upper surfaces were subjected to forced-air-cooling by an air blower.

The upper-surface temperature distributions of the first example, the comparative example, and the second example were monitored through an infrared thermography (TVS-200) made by Nippon Avionics Co., Ltd, when observed values became ones shown in table 1, and a verification test for comparing the thermal diffusion properties thereof were performed.

FIG. 29(A) represents a result of thermographic observation indicating the temperature distribution of the copper-made heat spreader of the comparative example. FIG. 29(B) shows the temperature distribution in a direction of a lateral axis which passes through the center of the copper plate of the copper-made heat spreader and runs from one heat dissipation fin to another heat dissipation fin opposite thereto. FIG. 29(C) shows the temperature distribution in a direction of a longitudinal axis which is perpendicular to the lateral axis, passes through the center of the copper plate of the copper-made heat spreader, and runs from one heat dissipation fin to another heat dissipation fin opposite thereto. In FIGS. 29(B) and 29(C), dashed lines at the center represent the temperature distribution of the copper plate, and dashed lines at both ends represent the temperature distribution between the copper plate and the heat dissipation fins. Table 1 below indicates the observed values in shooting by the thermography. Note that q in table 1 represents the heat generation density of the heater, V represents the output of the heater, and W represents the applied voltage to the heater.

**[Table 1]**

| Target value | | | Observed value | | | |
|---|---|---|---|---|---|---|
| q[kW/m²] | W_{target}[W] | V_{target}[W] | V[V] | W[W] | q[kW/m²] | Room temperature[°C] |
| 1200.0 | 30 | 38.73 | 38.4 | 29.5 | 1179.6 | 17.1 |

As is apparent from FIGS. 29(B) and 29(C), because the copper-made heat spreader had a large thermal resistance inherent to the bonding layer, there was a large temperature difference at a joining portion of the copper plate and the heat dissipation fin, and the temperature drastically dropped at the heat dissipation fin. It becomes apparent that heat discharge from the heat dissipation fin was quite little in comparison with the copper plate because the copper-made heat spreader had an extremely large temperature difference between the copper plate and the heat dissipation fin.

FIG. 28(A) represents a result of thermographic observation indicating the temperature distribution of the heat pipe of the first example. FIG. 28(B) shows the temperature distribution in a direction of a lateral axis which passes through the center of the cooling unit main body of the heat pipe, and runs from one heat dissipation fin to another heat dissipation fin. FIG. 28(C) shows the temperature distribution in a direction of the longitudinal axis which is perpendicular to the lateral axis, passes through the center of the cooling unit main body of the heat pipe, and runs from one heat dissipation fin to another heat dissipation fin opposite thereto. In FIGS. 28(B) and 28(C), dashed lines at the center represent the temperature distribution at the cooling unit main body, and dashed lines at both ends represent the temperature distribution between the cooling unit main body and the heat dissipation fin.

As is apparent from FIGS. 28(B) and 28(C), because the heat pipe of the invention had the heat dissipation fins formed continuously and integrally with the cooling unit main body, the temperature difference at a boundary between the cooling unit main body and the heat dissipation fin was small, and heat discharge from the heat dissipation fin was large like the cooling unit main body. That is, it becomes apparent from such a temperature distribution that the heat pipe of the first example had an extremely superior heat dissipation effect through the heat dissipation fin in comparison with the copper-made heat spreader.

Next, regarding the heat pipe of the first example provided with the heat dissipation fins and the heat pipe of the second example provided with no heat dissipation fin, the temperature distributions thereof were compared.

FIG. 30(A) represents a result of thermographic observation indicating the temperature distribution of the heat pipe of the second example which had no heat dissipation fin, and had capillary flow paths formed in the mounting section opposite region in the cooling unit main body. FIG. 30(B) shows the temperature distribution in the direction of a lateral axis which passes through the center of the heat pipe, and runs from one side of the cooling unit main body to another side opposite thereto.

FIG. 30(C) shows the temperature distribution in the direction of a longitudinal axis which passes through the center of the heat pipe, and runs from one side to another side opposite thereto. In FIGS. 30(B) and 30(C), dashed lines at the center represent the temperature distribution of the copper plate.

As is apparent from FIGS. 30(B) and 30(C) and table 2 below, it is confirmed that the heat pipe of the second example had a small temperature difference between the central portion and the peripheral portion thereof. It becomes apparent that the heat pipe of the second example had an extremely high thermal diffusion effect because the refrigerant circulated thereinside and the entire regions thereof including the corner portions contributed to heat dissipation uniformly.

Table 2 below shows the temperatures at individual locations in the first example, the comparative example, and the second example.

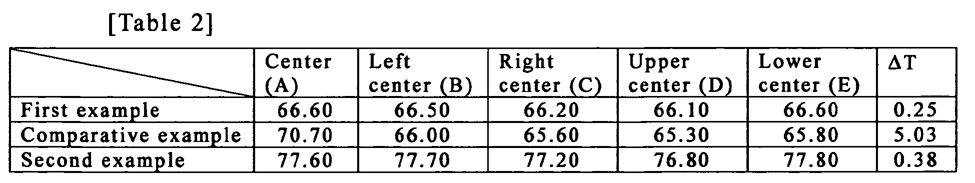

As is apparent from FIGS. 28(B), 28(C), and table 2, the heat pipe of the first example had the thermal diffusion property like the second example, and the steady temperature of the entire cooling unit main body was approximately 10 °C lower than that of the second example. This indicates that the heat pipe provided with the heat dissipation fins has a superior heat dissipation effect in comparison with the heat pipe provided with no heat dissipation fin. Table 3 below shows heat source temperatures and the observed values of a blower. Tₕ₁ represents temperatures at a contact surface of the heater with the heat pipes or the copper-made heat spreader, while Tₕ₂ represents temperatures at a non-contact surface of the heater with the heat pipes or the copper-made heat spreader (i.e., outside surface opposite to the contact surface.

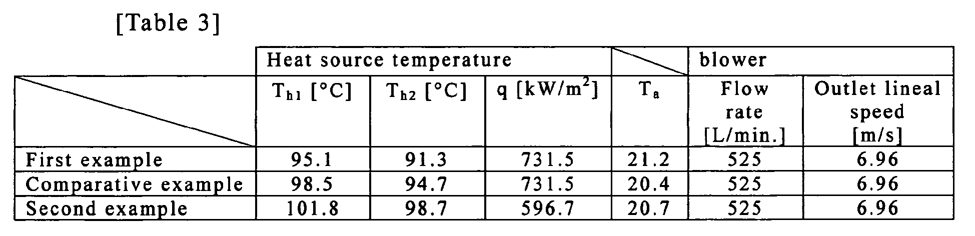

## Claims

1. A heat pipe comprising:
a cooling unit main body having an upper plate and a lower plate, either one of which being provided with a mounting section for mounting a device to be cooled, and one or a plurality of intermediate plates provided between said upper plate and said lower plate, wherein
a vapor diffusion flow path which causes a refrigerant to vaporize and transfer heat generated at said device to be cooled to a peripheral portion of said cooling unit main body, and a capillary flow path which is provided in said intermediate plate and returns said refrigerant that is condensed at said peripheral portion to said mounting section side are provided inside said cooling unit main body, and
said mounting section has a concave portion which has a thinner thickness than other areas and is for mounting said device to be cooled.

2. A heat pipe comprising:
a cooling unit main body having an upper plate and a lower plate, either one of which being provided with a mounting section for mounting a device to be cooled, and one or a plurality of intermediate plates provided between said upper plate and said lower plate, wherein
a vapor diffusion flow path which causes a refrigerant to vaporize and transfer heat generated at said device to be cooled to a peripheral portion of said cooling unit main body, and a capillary flow path which is provided in said intermediate plate and returns said refrigerant that is condensed at said peripheral portion to said mounting section side are provided inside said cooling unit main body, and
said capillary flow path is formed inside said cooling unit main body in a region facing said mounting section.

3. A heat pipe comprising:
a cooling unit main body having an upper plate and a lower plate, either one of which being provided with a mounting section for mounting a device to be cooled, and one or a plurality of intermediate plates provided between said upper plate and said lower plate, wherein
a vapor diffusion flow path which causes a refrigerant to vaporize and transfer heat generated at said device to be cooled to a peripheral portion of said cooling unit main body, and a capillary flow path which is provided in said intermediate plate and returns said refrigerant that is condensed at said peripheral portion to said mounting section side are provided inside said cooling unit main body, and
a heat dissipation fin is provided at an outer peripheral portion of any one of said upper plate, said lower plate, and said intermediate plate.

4. A heat pipe comprising:
a cooling unit main body having an upper plate and a lower plate, either one of which being provided with a mounting section for mounting a device to be cooled, and one or a plurality of intermediate plates provided between said upper plate and said lower plate, wherein
a vapor diffusion flow path which causes a refrigerant to vaporize and transfer heat generated at said device to be cooled to a peripheral portion of said cooling unit main body, and a capillary flow path which is provided in said intermediate plate and returns said refrigerant that is condensed at said peripheral portion to said mounting section side are provided inside said cooling unit main body,
said mounting section has a concave portion which has a thinner thickness than other areas and is for mounting said device to be cooled,
said capillary flow path is formed inside said cooling unit main body in a region facing said mounting section, and
a heat dissipation fin is provided at an outer peripheral portion of any one of said upper plate, said lower plate, and said intermediate plate.

5. The heat pipe according to claim 3 or 4, wherein said heat dissipation fin is formed continuously and integrally with said outer peripheral portion of said upper plate, said lower plate, or said intermediate plate.

6. The heat pipe according to any one of claims 3 to 5, wherein
heat dissipation fins are provided at outer peripheral portions of said upper plate, said lower plate, and said intermediate plate, respectively, and
said heat dissipation fin of said upper plate, said heat dissipation fin of said lower plate, and said heat dissipation fin of said intermediate plate do not contact one another when said upper plate, said lower plate, and said intermediate plate are stacked together.

7. The heat pipe according to any one of claims 3 to 6, wherein said heat dissipation fin is bent in parallel or at an arbitrary angle with respect to an upper surface of said upper plate or a lower surface of said lower plate.

8. The heat pipe according to any one of claims 3 to 7, wherein a heat dissipation fin of said upper plate, a heat dissipation fin of said lower plate, and a heat dissipation fin of said intermediate plate are formed in a formation pattern in such a manner as not to contact one another.

9. The heat pipe according to any one of claims 1 to 8, wherein
a plurality of through holes are formed in said intermediate plate, and displaced to one another for every adjoining intermediate plates, and
said capillary flow path is so formed as to incline in an oblique direction from a vertical direction with a direction between said upper plate and said lower plate taken as said vertical direction.

10. The heat pipe according to any one of claims 1 to 9, wherein said cooling unit main body and said device to be cooled and mounted thereon are formed as a single piece.

11. The heat pipe according to any one of claims 1 to 10, wherein said device to be cooled is a light emitting device.
